# EUROPEAN PATENT APPLICATION

(11) **EP 4 415 045 A2**
(43) Date of publication of application: **14.08.2024**
(21) Application number: 22878911.1
(22) Date of filing: 06.10.2022
(51) Int. Cl.: H01L 25/075, H01L 27/15, H01L 33/08, H01L 27/12, H01L 33/62

(54) **LED DISPLAY PIXEL ELEMENT AND DISPLAY DEVICE COMPRISING SAME**

(30) Priority: 06.10.2021 US 202163252865 P; 13.10.2021 US 202163255407 P; 19.12.2021 US 202163291449 P; 04.10.2022 US 202217960095
(71) Applicant: Seoul Viosys Co., Ltd., Ansan-si, Gyeonggi-do 15429 (KR)
(72) Inventor: JANG, Jong Min, Ansan-Si Gyeonggi-do 15429 (KR); LEE, Chung Hoon, Ansan-Si Gyeonggi-do 15429 (KR); SHIN, Jin Hwa, Ansan-Si Gyeonggi-do 15429 (KR); LEE, Sung Hyun, Ansan-Si Gyeonggi-do 15429 (KR); YUN, Seung Jo, Ansan-Si Gyeonggi-do 15429 (KR)
(74) Representative: Stolmár & Partner Patentanwälte PartG mbB
(86) International application number: PCT/KR2022/015036
(87) International publication number: WO 2023/059090

(57) **Abstract**

An LED display pixel element and a display device comprising same are provided. A pixel element according to one embodiment comprises: a pixel; a planarization layer covering the side surface and upper surface of the pixel; and pixel element pads disposed on the planarization layer, wherein the pixel comprises: a first light-emitting stack; a second light-emitting stack positioned beneath the first light-emitting stack; a third light-emitting stack positioned beneath the second light-emitting stack; and pixel pads electrically connected to the first to third light-emitting stacks, the pixel element pads are electrically connected to the pixel pads through the planarization layer, and at least a part of each of the pixel element pads is disposed on the planarization layer on the outside of the upper region of the pixel.

## Description

### [Technical Field]

The present disclosure relates to a pixel device for an LED display that implements an image using a light emitting diode and a display apparatus having the same.

### [Background Art]

Light emitting diodes are inorganic light sources, which are used in various fields such as display apparatuses, automobile lamps, general lighting, and the like. The light emitting diodes have advantages such as longer lifespan, lower power consumption, and quicker response, than conventional light sources, and thus, they have been replacing the conventional light sources.

The conventional light emitting diodes have been generally used as backlight light sources in display apparatuses. However, LED displays that directly realize images using the light emitting diodes have been recently developed.

In general, the display apparatus displays various colors through mixture of blue, green, and red light. In order to realize various images, the display apparatus includes a plurality of pixels, each of the pixels includes sub-pixels of blue, green, and red light, a color of a certain pixel is determined based on colors of the sub-pixels, and images can be realized through a combination of such pixels.

An LED display apparatus implements an image by using a very small LED in a micro unit. In order to manufacture the LED display apparatus, numerous pixel devices are manufactured, and the pixel devices are mounted on a circuit board using pads formed on the pixel devices. In order to stably mount the pixel devices on the circuit board, it is necessary to sufficiently secure sizes of pads formed on the pixel devices.

Meanwhile, in order to reduce a manufacturing cost of the LED display apparatus, it is necessary to increase the number of pixels produced using one wafer. However, reduction in a size of the pixel device reduces the sizes of pads formed on the pixel device, thereby making it difficult to mount the pixel device.

### [Disclosure]

### [Technical Problem]

Exemplary embodiments provide a pixel device having pads of sufficient sizes while increasing the number of pixels that can be manufactured using one wafer and a display apparatus having the same.

Exemplary embodiments provide a pixel device suitable for being stably mounted on a circuit board without a contact failure, and a display apparatus having the same.

### [Technical Solution]

A pixel device according to an exemplary embodiment includes: a pixel; a planarization layer covering side surfaces and an upper surface of the pixel; and pixel device pads disposed on the planarization layer, in which the pixel includes: a first light emitting stack; a second light emitting stack disposed under the first light emitting stack; a third light emitting stack disposed under the second light emitting stack; and pixel pads electrically connected to the first through third light emitting stacks, in which the pixel device pads are electrically connected to the pixel pads through the planarization layer, in which at least a portion of each of the pixel device pads is disposed on the planarization layer outside of an upper region of the pixel.

As used herein, a term "pixel device" refers to a unit device configured to be mounted on a circuit board. The pixel device includes a pixel device pad (or an connection electrode) configured so as to be electrically connected to the circuit board. The pixel device may include one or more pixels, and in this specification, a pixel device including a single pixel will be referred to as a unit pixel device. Also, a pixel device including a plurality of pixels may be referred to as a multi-pixel device. Meanwhile, the pixel is generally a basic unit constituting an image in a display. To implement a color image, one pixel may include at least three sub-pixels each emitting a single color. Structurally, a term "pixel" refers to a combination of the sub-pixels, and the sub-pixels are stacked on above another.

The planarization layer may have an opening exposing the pixel pads, and the pixel device pads may be electrically connected to the pixel pads through the opening.

The pixel device may further include a protection layer covering the opening. The protection layer may cover the pixel device pads, and may have openings exposing the pixel device pads. Pad regions may be defined by the openings of the protection layer.

The pixel device may further include a transparent substrate, and an adhesive layer disposed between the transparent substrate and the pixel to attach the pixel to the transparent substrate.

The pixel device may further include a light blocking layer disposed on the transparent substrate to define a light emitting region, and the pixel may be disposed on the light emitting region.

The pixel device may include at least two pixels.

The pixel device may further include at least one interconnection layer disposed on the planarization layer, and the pixel device pad may be electrically connected to the pixel pads through the interconnection layer.

The pixel device may further include a first intermediate layer disposed on the planarization layer, and a second intermediate layer disposed on the first intermediate layer, in which the interconnection layer may include a first interconnection layer disposed between the planarization layer and the first intermediate layer, and a second interconnection layer disposed between the first intermediate layer and the second intermediate layer, in which the pixel device pad may be disposed on the second intermediate layer, and electrically connected to the pixel pads through the first and second interconnection layers.

The pixel device may further include a lower insulation layer disposed between the planarization layer and the first interconnection layer.

The plurality of pixels may be arranged in a matrix of n×m (n and m are positive integers), and the number of the pixel device pads may be less than 4×n×m.

The number of the pixel device pads may be (3n+m) or more and 2×n×m or less.

In an exemplary embodiment, lower surfaces of the pixels may be exposed on a bottom surface of the pixel device.

A size of one side of the pixel device may be 1.5 times or more of a size of one side of the pixel.

A pixel device according to an exemplary embodiment of the present disclosure includes: a plurality of pixels; a planarization layer covering side surfaces and upper surfaces of the plurality of pixels; an intermediate layer disposed over the planarization layer; pixel device pads disposed over the intermediate layer; and an interconnection layer disposed between the planarization layer and the intermediate layer, in which the pixels include a first light emitting stack; a second light emitting stack disposed under the first light emitting stack; a third light emitting stack disposed under the second light emitting stack; and pixel pads electrically connected to the first through third light emitting stacks, respectively, in which the pixel device pads are electrically connected to the pixel pads through the interconnection layer, and at least a portion of each of the pixel device pads is disposed over the planarization layer outside of an upper region of the pixels.

The intermediate layer may include a first intermediate layer disposed on the planarization layer, and a second intermediate layer disposed on the first intermediate layer, in which the interconnection layer may include a first intermediate layer disposed between the planarization layer and the first intermediate layer, and a second interconnection layer disposed between the first intermediate layer and the second intermediate layer, in which the pixel device pads may be disposed on the second intermediate layer, and may be electrically connected to the pixel pads through the first and second interconnection layers.

The plurality of pixels may be arranged in a matrix of n×m (n and m are positive integers), and the number of the pixel device pads may be (3n+m) or more and 2×n×m or less.

A display apparatus according to an exemplary embodiment includes: a circuit board; and a pixel device disposed on the circuit board, in which the pixel device includes: a pixel; a planarization layer covering side surfaces and an upper surface of the pixel; and pixel device pads disposed on the planarization layer, in which the pixel includes: a first light emitting stack; a second light emitting stack disposed under the first light emitting stack; a third light emitting stack disposed under the second light emitting stack; and pixel pads electrically connected to the first through third light emitting stacks, in which the pixel device pads are electrically connected to the pixel pads through the planarization layer, in which at least a portion of each of the pixel device pads is disposed on the planarization layer outside of an upper region of the pixel, and the pixel device pads are bonded to the circuit board.

The pixel device may further include at least one interconnection layer disposed on the planarization layer. Further, the pixel device includes a plurality of pixels, the planarization layer covers side surfaces and upper surfaces of the plurality of pixels, and the pixel pad devices are disposed over the interconnection layer. The pixel device pads may be electrically connected to the pixel pads through the interconnection layer.

The pixel device may include: a first intermediate layer disposed on the planarization layer; and a second intermediate layer disposed on the first intermediate layer, in which the interconnection layer may include a first intermediate layer disposed between the planarization layer and the first intermediate layer, and a second interconnection layer disposed between the first intermediate layer and the second intermediate layer, in which the pixel device pads may be disposed on the second intermediate layer, and may be electrically connected to the pixel pads through the first and second interconnection layers.

### [Description of Drawings]

FIG. 1A is a schematic plan view illustrating a display apparatus according to an exemplary embodiment.
FIG. 1B are schematic perspective views illustrating various display apparatuses according to an exemplary embodiment.
FIG. 2 is a schematic plan view illustrating a pixel device according to an exemplary embodiment.
FIG. 3 is a schematic cross-sectional view taken along line I - I' of its corresponding plan view shown in FIG. 2.
FIG. 4 is a schematic plan view illustrating a pixel device according to an exemplary embodiment.
FIG. 5 is a schematic cross-sectional view taken along line II- II' of its corresponding plan view shown in FIG. 4.
FIG. 6 is a schematic circuit diagram of the pixel device of FIG. 4.
FIG. 7 is a schematic cross-sectional view illustrating a pixel device according to an exemplary embodiment.
FIG. 8 is a schematic cross-sectional view illustrating a pixel device according to an exemplary embodiment.
FIG. 9 is a schematic plan view illustrating a pixel device according to an exemplary embodiment.
FIG. 10 is a schematic plan view illustrating a pixel device according to an exemplary embodiment.
FIG. 11 is a schematic circuit diagram of the pixel device of FIG. 10.
FIG. 12A is a schematic plan view illustrating a pixel device according to an exemplary embodiment.
FIG. 12B is a schematic cross-sectional view taken along line A-A' of its corresponding plan view shown in FIG. 12A.
FIG. 12C is a schematic cross-sectional view taken along line B-B' of its corresponding plan view shown in FIG. 12A.
FIG. 13A is a schematic cross-sectional view illustrating a method of manufacturing a first sub-pixel of a pixel device according to an exemplary embodiment.
FIG. 13B is a schematic cross-sectional view illustrating a method of manufacturing a second sub-pixel of a pixel device according to an exemplary embodiment.
FIG. 13C is a schematic cross-sectional view illustrating a method of manufacturing a third sub-pixel of a pixel device according to an exemplary embodiment.
FIG. 14 is a schematic cross-sectional view illustrating a stacked structure of a pixel according to an exemplary embodiment.
FIGS. 15A, 16A, 17A, 18A, 19A, 20A, 21A, 22A, 23A, 24A, and 25A are plan views illustrating a method of manufacturing a pixel device according to an exemplary embodiment.
FIGS. 15B, 16B, 17B, 18B, 19B, 20B, 21B, 22B, 23B, 24B, and 25B are cross-sectional views taken along line A-A' of its corresponding plan view shown in FIGS. 15A, 16A, 17A, 18A, 19A, 20A, 21A, 22A, 23A, 24A, and 25A.
FIGS. 15C, 16C, 17C, 18C, 19C, 20C, 21C, 22C, 23C, 24C, and 25C are schematic cross-sectional views taken along line B-B' of its corresponding plan view shown in FIGS. 15A, 16A, 17A, 18A, 19A, 20A, 21A, 22A, 23A, 24A, and 25A.
FIG. 26A and FIG. 26B are schematic cross-sectional views illustrating modifications of pixel devices according to an exemplary embodiment.
FIG. 27 is a schematic cross-sectional view illustrating a pixel module having pixel devices according to an exemplary embodiment.
FIG. 28 is a schematic cross-sectional view illustrating a pixel device according to an exemplary embodiment.
FIGS. 29A, 29B, 29C, and 29D are schematic plan views illustrating a method of forming a pad of a pixel device according to an exemplary embodiment.

### [Detailed Description of the Illustrated Exemplary Embodiments]

Hereinafter, embodiments will be described in detail with reference to the accompanying drawings. The following embodiments are provided by way of example so as to fully convey the spirit of the present disclosure to those skilled in the art to which the present disclosure pertains. Accordingly, the present disclosure is not limited to the embodiments disclosed herein and can also be implemented in different forms. In the drawings, widths, lengths, thicknesses, and the like of elements can be exaggerated for clarity and descriptive purposes. When an element or layer is referred to as being "disposed above" or "disposed on" another element or layer, it can be directly "disposed above" or "disposed on" the other element or layer or intervening elements or layers can be present. Throughout the specification, like reference numerals denote like elements having the same or similar functions.

Hereinafter, exemplary embodiments of the present disclosure will be described in detail with reference to the accompanying drawings.

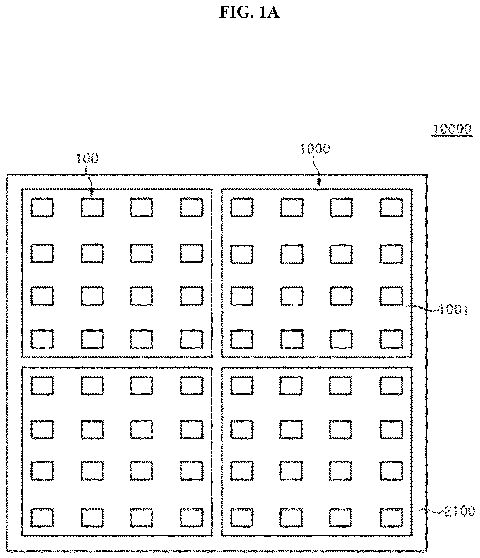

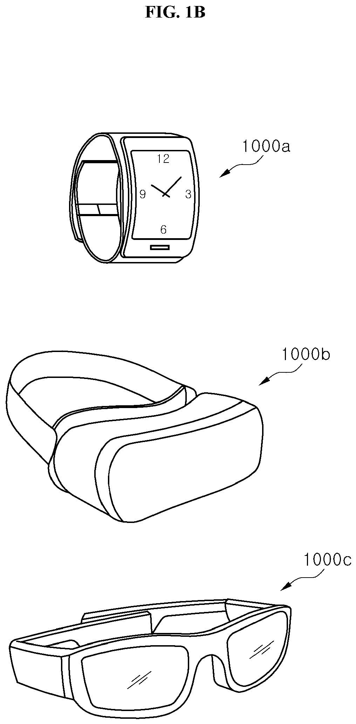

FIG. 1A is a schematic plan view illustrating a display apparatus according to an exemplary embodiment, and FIG. 1B are schematic perspective views illustrating various display apparatuses 1000a, 1000b, and 1000c according to an exemplary embodiment.

Referring to FIG. 1A, a display apparatus 10000 may include a panel substrate 2100 and a plurality of pixel modules 1000.

The display apparatus 10000 is not particularly limited, but may include a VR display apparatus 1000b such as a micro LED TV, a smart watch 1000a, a VR headset, or an AR display apparatus 1000c such augmented reality glasses. The panel substrate 2100 and the plurality of pixel modules 1000 may be disposed in the display apparatus. A gap between pixels in the display apparatus may be very narrow, for example, the gap between pixels may be 0.01 mm or less. The display apparatus may implement an image through pixels mounted on a circuit board or a transparent substrate. In some display apparatuses, a distance between the display apparatus and an external receiver (e.g., a user's eyes) that recognizes the display may be 200 mm or less. The gap between pixels may be 0.005% to 0.1% of the distance between the external receiver and the display apparatus. The display apparatus may transmit an optical signal from a substrate including a curved surface to the external receiver.

The panel substrate 2100 may include a circuit for a passive matrix driving or active matrix driving manner. In an exemplary embodiment, the panel substrate 2100 may include wirings and resistors therein, and, in another exemplary embodiment, the panel substrate 2100 may include wirings, transistors, and capacitors. The panel substrate 2100 may also have pads that are capable of being electrically connected to the disposed circuit on an upper surface thereof.

In an exemplary embodiment, the plurality of pixel modules 1000 is arranged on the panel substrate 2100. Each of the pixel modules 1000 may include a circuit board 1001, and a plurality of pixel devices 100 disposed on the circuit board 1001, and may include a molding member covering the pixel devices 100. In another exemplary embodiment, the plurality of pixel devices 100 may be directly arranged on the panel substrate 2100, and the molding member may cover the pixel devices 100.

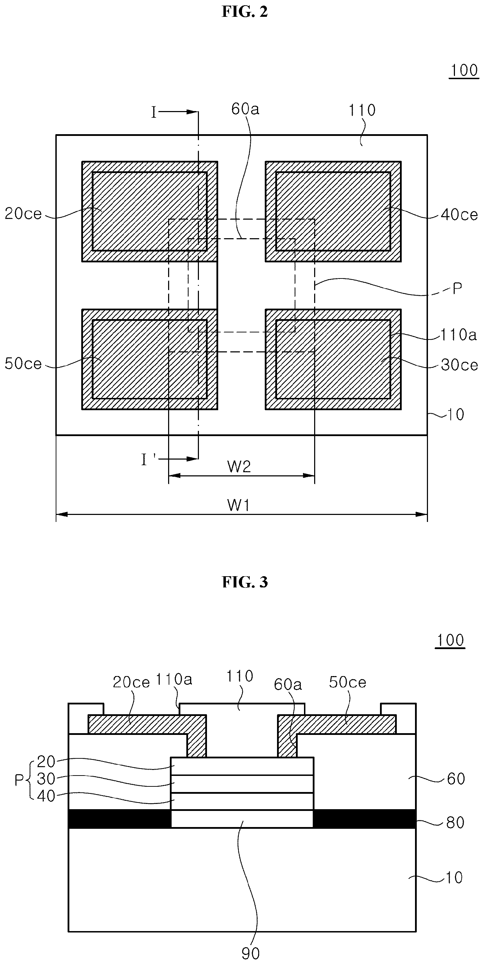

Hereinafter, the pixel device 100 will be described in detail with reference to FIG. 2 and FIG. 3.

FIG. 2 is a schematic plan view illustrating the pixel device 100 according to an exemplary embodiment, and FIG. 3 is a schematic cross-sectional view taken along line I- I' of its corresponding plan view shown in FIG. 2.

Referring to FIG. 2 and FIG. 3, the pixel device 100 may include a substrate 10, a light blocking layer 80, an adhesive layer 90, a pixel P, a first connection electrode 20ce, and a second connection electrode 30ce, a third connection electrode 40ce, and a fourth connection electrode 50ce. Furthermore, the pixel device 100 may include a planarization layer 60 and a protection layer 110.

The substrate 10 is a transparent substrate that transmits light generated in the pixel P, and may include a light-transmissive insulating material. In some exemplary embodiments, the substrate 10 may be translucent or partially transparent so as to transmit only light of a specific wavelength or only a portion of light of a specific wavelength. The substrate 10 may include glass, quartz, silicon, an organic polymer, or an organic-inorganic composite material, for example, silicon carbide (SiC), gallium nitride (GaN), indium gallium nitride (InGaN), aluminum gallium nitride (AlGaN), aluminum nitride (AlN), gallium oxide (Ga₂O₃) substrate, and the like.

The light blocking layer 80 is disposed on the substrate 10. The light blocking layer 80 may define a region that transmits light generated in the pixel P, that is, a light emitting region. The light blocking layer 80 may be disposed so as to surround the light emitting region. The light blocking layer 80 may be formed of, for example, a black matrix, and may prevent cross-talk between pixels P in the display apparatus 10000 to improve a contrast ratio.

The light blocking layer 80 may have a shape with a flat surface on one side such that a thickness of the planarization layer 60 formed on one surface of the light blocking layer 80 is uniform. Alternatively, when viewed from the outside, it may include a shape having a curved surface so as to prevent light reflection and to make the surface appear scattered.

The adhesive layer 90 adheres the pixel P to the substrate 10. The adhesive layer 90 may cover the light emitting region defined by the light blocking layer 80. Although the adhesive layer 90 is shown as being disposed within the light emitting region in FIG. 3, the adhesive layer 90 may cover the light blocking layer 80. The adhesive layer 90 may include an optically clear adhesive (OCA), which, for example, may include epoxy, polyimide, SU8, spin-on-glass (SOG), benzocyclobutene (BCB), without being limited thereto.

The pixel P may include a first LED sub-pixel, a second LED sub-pixel, and a third LED sub-pixel. The first LED sub-pixel may include a first light-emitting stack 20, the second LED sub-pixel may include a second light-emitting stack 30, and the third LED sub-pixel may include a third light-emitting stack 40. The first light emitting stack 20, the second light emitting stack 30, and the third light emitting stack 40 may include a first conductivity type semiconductor layer, a second conductivity type semiconductor layer, and an active layer disposed therebetween, respectively. The first, second, and third light emitting stacks 20, 30, and 40 are configured so as to emit light toward the substrate 10. Accordingly, light emitted from the first light emitting stack 20 may pass through the second and third light emitting stacks 30 and 40. According to an exemplary embodiment, the first, second, and third light emitting stacks 20, 30, and 40 may emit light of different peak wavelengths from one another. In an exemplary embodiment, the light emitting stack disposed further away from the substrate 10 may reduce light loss by emitting light of a longer wavelength than the light emitting stack disposed close to the substrate 10. For example, the first light emitting stack 20 may emit red light, the second light emitting stack 30 may emit green light, and the third light emitting stack 40 may emit blue light.

In another exemplary embodiment, the pixel P may comprise sub-pixels P1, P2, and P3 each including a first conductivity type semiconductor layer, an active layer, and a second conductivity type semiconductor layer, and it may be in a form that each of the sub-pixels P1, P2, and P3 may be arranged adjacent to one another with the planarization layer 60 interposed therebetween. In this case, each of the sub-pixels P1, P2, and P3 emits light of different peak wavelengths from one another. Optionally, it may further include a sub-pixel P4, in which the sub-pixel P4 may be disposed so as to serve as an additional pixel for repair when any one pixel is not driven, or may be disposed so as to serve as an additional pixel for implementing a more visible display.

In another exemplary embodiment, the second light emitting stack 30 may emit light of a shorter wavelength than the third light emitting stack 40. A portion of light emitted from the second light emitting stack 30 may be absorbed by the third light emitting stack 40. Accordingly, it is possible to reduce a luminous intensity of the second light emitting stack 30 and increase a luminous intensity of the third light emitting stack 40, and thus, a luminous intensity ratio of light emitted from the first, second, and third light emitting stacks may be modified. For example, the first light emitting stack 20 may be configured to emit red light, the second light emitting stack 30 to emit blue light, and the third light emitting stack 40 to emit green light. Accordingly, it is possible to relatively reduce the luminous intensity of blue light and relatively increase the luminous intensity of green light, and using this, the luminous intensity ratio of red, green, and blue may be easily adjusted to be close to 3:6: 1.

A length w1 of one side of the pixel device 100 may be 1.5 times or more, and further, more than 2 times of a length w2 of one side of the pixel P. For example, the length w2 of one side of the pixel P may be 110um or less, and the length w1 of one side of the pixel device 100 may be 220um or less. Alternatively, the length w1 of one side of the pixel device 100 may be included in a range of 1.5 to 3 times of the length w2 of one side of the pixel P. Emission areas on of the first, second, and third light emitting stacks 20, 30, and 40 in the pixel P, that is, an area of the active layer may be about 10,000 um² or less, further, 4,000 um², furthermore, 2,500 um² or less. In addition, the closer the substrate 10 is, the larger the emission area may be, and the luminous intensity of green light may be further increased by disposing the third light emitting stack 40 emitting green light closest to the substrate 10. Hereinafter, it is exemplarily described that the second light emitting stack 30 emits light of a shorter wavelength than the third light emitting stack 40, for example, blue light, but the second light emitting stack 30 may emit light of a longer wavelength than the third light emitting stack 40, for example, green light.

The first light emitting stack 20 may include a semiconductor material emitting red light such as AlGaAs, GaAsP, AlGaInP, and GaP, without being limited thereto. The second light emitting stack 30 may include a semiconductor material emitting blue light, such as GaN, InGaN, ZnSe, or the like, without being limited thereto. The third light emitting stack 40 may include a semiconductor material that emits green light, such as GaN, InGaN, GaP, AlGaInP, AlGaP, or the like. The pixel P may further include an ohmic electrode layer, an adhesive layer, and pixel pads connected to the connection electrodes 20ce, 30ce, 40ce, and 50ce in addition to the light emitting stacks 20, 30, and 40.

According to an exemplary embodiment, each of the first conductivity type semiconductor layers and the second conductivity type semiconductor layers of the first, second, and third light emitting stacks 20, 30, and 40 may have a single-layer structure or a multi-layer structure, and in some exemplary embodiments, may include a superlattice layer. Moreover, the active layers of the first, second, and third light emitting stacks 20, 30, and 40 may have a single quantum well structure or a multiple quantum well structure.

The planarization layer 60 may cover the pixel P to provide a flat surface over the pixel P. The planarization layer 60 may be formed of, for example, polyimide (PI), PDMA, or black epoxy molding compound (EMC). The planarization layer 60 may also cover an upper portion of the substrate 10 around the pixel P. The planarization layer 60 may cover the light blocking layer 80, and may cover the side surface of the pixel P. Accordingly, the planarization layer 60 provides an upper surface having a larger area than that of the pixel P. The planarization layer 60 may have an opening 60a through which the pixel P is exposed. The opening 60a may expose pixel pads (not shown) electrically connected to the first through third light emitting stacks 20, 30, and 40. In the illustrated exemplary embodiment, it is shown that one opening 60a is formed, but the inventive concepts are not limited thereto, and a plurality of openings may be formed so as to respectively expose pixel pads. The planarization layer 60 may be formed using, for example, a molding technology.

The first through fourth connection electrodes 20ce, 30ce, 40ce, and 50ce are formed on the planarization layer 60. The first through fourth connection electrodes 20ce, 30ce, 40ce, and 50ce may be partially overlapped with the pixel P, and extend outside of an upper region of the pixel P as shown in FIG. 2. Since the first through fourth connection electrodes 20ce, 30ce, 40ce, and 50ce are disposed on the planarization layer 60 having the larger area than that of the pixel P, they may have relatively larger areas than the pixel pads that are limitedly formed on the pixel P.

The first through fourth connection electrodes 20ce, 30ce, 40ce, and 50ce may be electrically connected to the pixel pads through the opening 60a. Accordingly, the first through fourth connection electrodes 20ce, 30ce, 40ce, and 50ce may be electrically connected to the first through third light emitting stacks 20, 30, and 40. For example, the first through third connection electrodes 20ce, 30ce, and 40ce may be electrically connected to the second conductivity type semiconductor layers of the first through third light emitting stacks 20, 30, and 40, respectively, and the fourth connection electrode 50ce may be commonly electrically connected to the first conductivity type semiconductor layers of the first through third light emitting stacks 20, 30, and 40. The first through third light emitting stacks 20, 30, and 40 may be independently driven using the first through fourth connection electrodes 20ce, 30ce, 40ce and 50ce.

The first through fourth connection electrodes 20ce, 30ce, 40ce, and 50ce may be formed using various deposition technologies, lift-off technology, or patterning technology such as photolithography and development technologies. The first through fourth connection electrodes 20ce, 30ce, 40ce, and 50ce may be formed so as to extend to an upper surface of the pixel P along side surfaces of the opening 60a of the planarization layer 60 from the pixel P as shown in FIG. 3.

The protection layer 110 may be formed on the pixel P and the first through fourth connection electrodes 20ce, 30ce, 40ce, and 50ce. The protection layer 110 is formed as an insulation layer, and a material of the protection layer 110 is not particularly limited. The protection layer 110 may cover and protect the pixel P or the first through fourth connection electrodes 20ce, 30ce, 40ce, and 50ce. The protection layer 110 may have openings 110a exposing the first through fourth connection electrodes 20ce, 30ce, 40ce, and 50ce. Pad regions to be mounted on the circuit board may be defined by the openings 110a. The connection electrodes 20ce, 30ce, 40ce, and 50ce are connected to pads on the circuit board, and portions of connection electrodes 20ce, 30ce, 40ce, and 50ce that are connected to the pads on the circuit board, for example, pad regions, may be referred to as pixel device pads so as to distinguish them from a pixel P pad, respectively. The protection layer 110 may be omitted, and thus, portions of the connection electrodes 20c2, 30ce, 40ce and 50ce disposed on the planarization layer 60 may become pixel device pads.

The pixel device 100 according to the illustrated exemplary embodiment has an external size of 1.5 times or more of a size of the pixel P, which is relatively larger than that of the pixel P. Accordingly, the pad regions formed by the first through fourth connection electrodes 20ce, 30ce, 40ce, and 50ce may be secured relatively wide.

Furthermore, the pixel device 100 includes the substrate 10 having a size relatively larger than that of the pixel P. A conventional pixel device includes a substrate corresponding to the size of the pixel P, and as the size of the pixel P decreases, it becomes difficult to dice the substrate. In contrast, in the illustrated exemplary embodiment, since the substrate 10 is relatively large compared to the size of the pixel P, a burden on dicing may be reduced.

The pixel device described with reference to FIG. 2 and FIG. 3 is a unit pixel device including a single pixel. A plurality of pixels P is formed on a first substrate (wafer), and these pixels P may be divided and arranged on a plurality of substrates 10. The plurality of pixels P may be separated from the first substrate using a laser lift-off technology or the like, and may be rearranged on a substrate on which the light blocking layer 80 and the adhesive layer 90 are formed. Since the pixels are divided and arranged on a plurality of second substrates 10, a distance between the pixels P disposed on the second substrates 10 is greater than a distance between the pixels P on the first substrate. Thereafter, the planarization layer 60, the connection electrodes 20ce, 30ce, 40ce, and 50ce, and the protection layer 110 may be formed on each of the second substrates 10, and then, the second substrates 10 may be divided into the pixel devices 100 using a dicing technology.

According to a prior art, pixels formed on a first substrate are diced together with the first substrate to manufacture a pixel device. Accordingly, the pixel may have substantially a same area as that of the first substrate. In this case, for example, when manufacturing pixel devices having a size of approximately 225um × 225um, approximately 140,000 pixel devices may be manufactured using a single first substrate using the first substrate having a size of 4 inches. In the prior art, it is difficult to reduce the size of the pixel device in consideration of the size of the pads.

In contrast, in the case that the second substrate 10 is diced after 110um × 110um pixels are manufactured on the first substrate and transferred to the second substrate 10, approximately 600,000 pixels may be manufactured on the first substrate with the size of 4 inches, and pixel devices having a size of approximately 220um × 220um may be manufactured by arranging them on four second substrates 10. Accordingly, it is possible to increase the number of pixels formed on the single first substrate, thereby significantly reducing a manufacturing cost of the pixel device.

Hereinafter, a pixel device according to another exemplary embodiment capable of increasing the pad size will be described. Herein, the pixel device described is a multi-pixel device including a plurality of pixels.

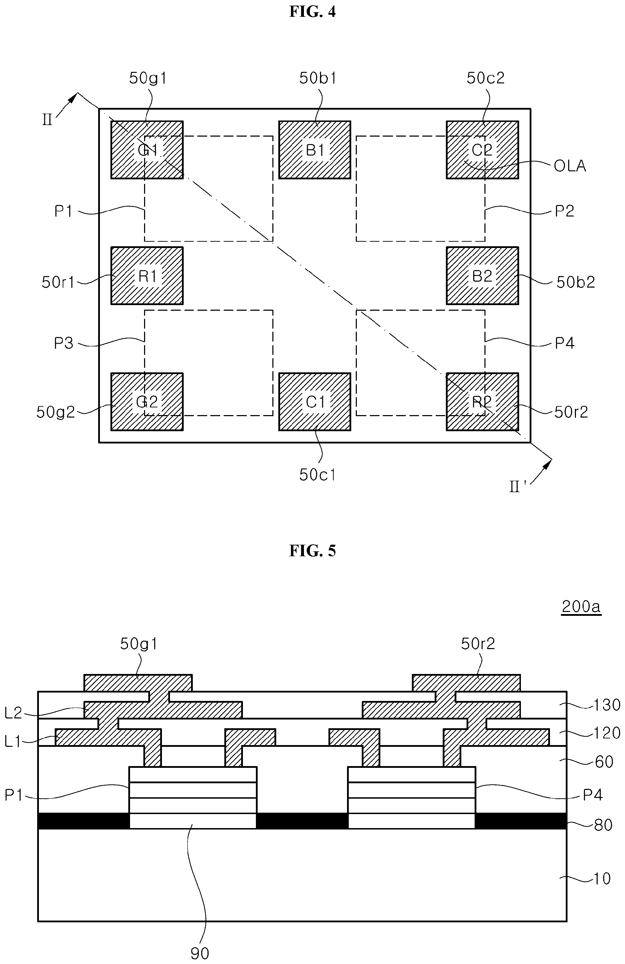

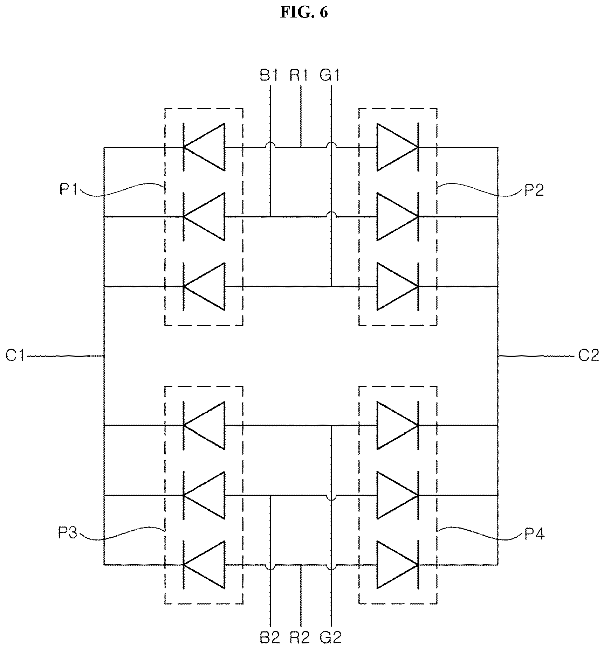

FIG. 4 is a schematic plan view illustrating a pixel device 200a according to an exemplary embodiment, FIG. 5 is a schematic cross-sectional view taken along line II- II' of its corresponding plan view shown in FIG. 4, and FIG. 6 is a schematic circuit diagram of the pixel device of FIG. 4.

Referring to FIG. 4 through FIG. 6, the pixel device 200a according to the illustrated exemplary embodiment may include a substrate 10, a light blocking layer 80, an adhesive layer 90, and four pixels P1, P2, P3, and P4, a planarization layer 60, a first layer L1, a second layer L2, a first intermediate layer 120, a second intermediate layer 130, and pixel device pads 50g1, 50g2, 50b1, 50b2, 50r1, 50r2, 50c1, and 50c2.

Since the substrate 10, the light blocking layer 80, the adhesive layer 90, and the planarization layer 60 are substantially similar to those described with reference to FIGS. 2 and 3, detailed descriptions thereof will be omitted to avoid redundancy.

The pixels P1, P2, P3, and P4 are arranged on the substrate 10. A size of the substrate 10 exceeds twice of a size of each pixel. Alternatively, the size of the substrate 10 may be two times or more and three times or less of the size of each pixel. The pixels P1, P2, P3, and P4 may have same structures from one another, and may have a same structure as that of the pixel P described with reference to FIGS. 2 and 3. Each of the pixels P1, P2, P3, and P4 may have four pixel pads. The pixels P1, P2, P3, and P4 may be attached to the substrate 10 by the adhesive layer 90. In the illustrated exemplary embodiment, a plurality of adhesive layers 90 is exemplarily described as attaching the pixels P1, P2, P3, and P4 to the substrate 10, but one adhesive layer 90 may cover the substrate 10 and the light blocking layer 80, and pixels P1, P2, P3, and P4 may be attached onto the adhesive layer 90.

At least one corner of the pixels P1, P2, P3, and P4 may be disposed so as to be vertically overlapped with at least one of the pixel device pads 50g1, 50g2, 50b1, 50b2, 50r1, 50r2, 50c1, and 50c2, and as shown in FIG. 4, an overlapping area OLA between the pixel device pad and the pixel may be formed. Among the corners of each pixel, farthest corners, for example, outer corners of pixels arranged in a diagonal direction in FIG. 4 may be overlapped with different pixel device pads.

The first layer L1 may be disposed on the planarization layer 60, the second layer L2 may be disposed on the first intermediate layer 120, and the pixel device pads 50g1, 50g2, 50b1, 50b2, 50r1, 50r2, 50c1, and 50c2 may be disposed on the second intermediate layer 130. Although it has been described that the first layer L1 is disposed on the planarization layer 60, a lower insulation layer may be added on the planarization layer 60, and the first layer L1 may be disposed on the lower insulation layer.

In cross section view, a location of a side surface of the first layer L1 and a location of a side surface of the second layer L2 may be disposed so as not to be overlapped vertically. That is, by disposing the side surfaces such that they are not flush with one another, a bonding strength between the first intermediate layer 120 and the second intermediate layer 130 may be increased.

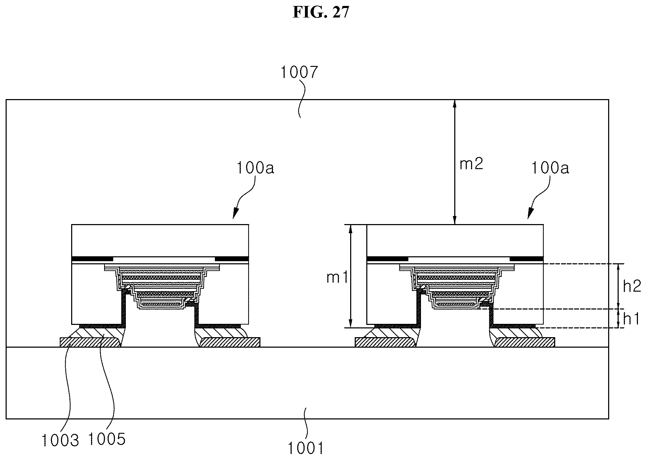

The pixels P1, P2, P3, and P4 may constitute a circuit as illustrated in FIG. 6 using the first layer L1 and the second layer L2. For example, the first layer L1 may connect portions of the corresponding pixel pads of the pixels P1, P2, P3, and P4 to one another, and the second layer L2 may connect remaining portions of corresponding pixel pads of the pixels P1, P2, P3, and P4 to one other. Finally, eight pixel device pads 50g1, 50g2, 50b1, 50b2, 50r1, 50r2, 50c1, and 50c2 may be disposed on the second intermediate layer 130. In the illustrated exemplary embodiment, it has been described that the circuit of FIG. 6 is configured using the first layer L1, the second layer L2, and the pixel device pads 50g1, 50g2, 50b1, 50b2, 50r1, 50r2, 50c1, and 50c2, but the inventive concepts are not limited thereto. As long as the circuit of FIG. 6 is configured, the number of electrical connection layers is not particularly limited. A method of electrically connecting the pixel pads will be described in detail later with reference to FIGS. 27A through 27D.

Referring to FIG. 6, three light emitting diodes of the first through third light emitting stacks 20, 30, and 40 are disposed in each of the pixels P1, P2, P3, and P4. Anodes of light emitting diodes in the pixel P1 are commonly electrically connected to anodes of light emitting diodes in the pixel P2, respectively, and also electrically connected to three pixel device pads B1, R1, and G1, respectively. In addition, anodes of light emitting diodes in the pixel P3 are commonly electrically connected to anodes of light emitting diodes in the pixel P4, and are electrically connected to three pixel device pads B2, R2, and G2 respectively.

Meanwhile, cathodes of the light emitting diodes in the pixel P1 and cathodes of the light emitting diodes in the pixel P3 are commonly electrically connected and electrically connected to a pixel device pad C 1. In addition, cathodes of the light emitting diodes in the pixel P2 and cathodes of the light emitting diodes in the pixel P4 are commonly electrically connected and electrically connected to a pixel device pad C2.

The light emitting diodes in each pixel may be individually driven by selecting common pixel device pads C1 and C2 and the individual pixel device pads R1, G1, B1, R2, G2, and B2.

Since 4 pixels have 4 pixel pads, respectively, a total of 16 pixel device pads may be required, but the light emitting diodes in 4 pixels may be individually driven with only 8 pixel device pads by commonly connecting the anodes and cathodes of the light emitting diodes to one another as in the illustrated exemplary embodiment. Accordingly, 8 pixel device pads may be formed to have relative large areas, and thus, it is possible to easily and stably mount the pixel device 200a on a circuit board.

According to the illustrated exemplary embodiment, as the pixel device 200a includes a larger number of pixels, sizes of the pixel device pads may be further increased. Furthermore, in the illustrated exemplary embodiment, the first and second intermediate layers 120 and 130, the first layer L1, the second layer L2, and the pixel device pads 50g1, 50g2, 50b1, 50b2, 50r1, 50r2, 50c1 and 50c2 may be formed on the pixel device 200a using a semiconductor manufacturing process, for example, a deposition and patterning process. Accordingly, there is no need to use a metal bonding material between the pixel pads and the pixel device pads 50g1, 50g2, 50b1, 50b2, 50r1, 50r2, 50c1, and 50c2.

According to the illustrated exemplary embodiment, the sizes of the pixel device pads may be increased by forming the number of pixel device pads to be smaller than the number of pixel pads, and thus, the pixels may be stably mounted on the circuit board. In the illustrated exemplary embodiment, pixels each having vertically stacked light emitting stacks are exemplarily described, but a technology for reducing the number of pixel device pads according to the illustrated exemplary embodiment is not limited to the vertically stacked pixels, and it may be applied to pixels of any structure having 4 or more pixel pads. For example, even in a lateral arrangement structure in which one pixel is configured by laterally arranging light emitting devices emitting light of different colors from one another, a plurality of pixels each having four pixel pads may be connected to a smaller number of pixel device pads.

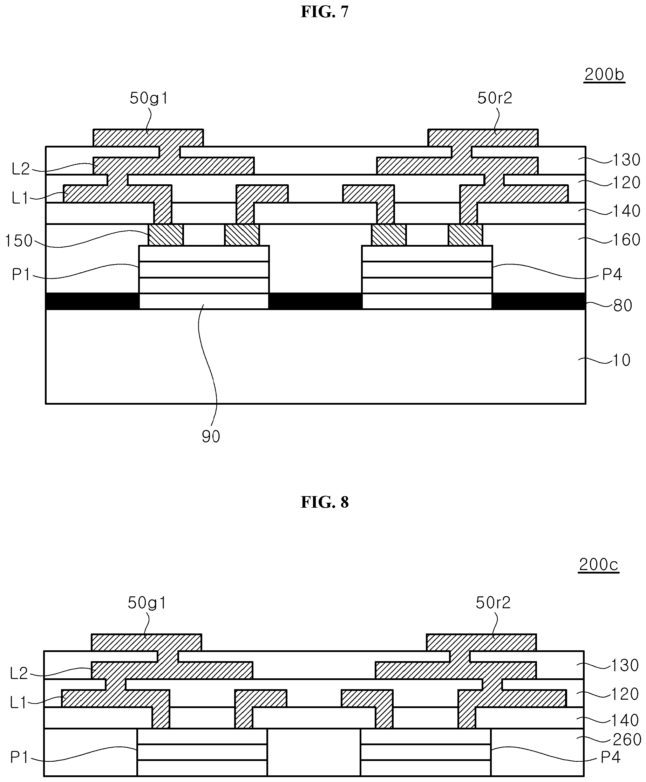

FIG. 7 is a schematic cross-sectional view illustrating a pixel device 200b according to an exemplary embodiment.

Referring to FIG. 7, the pixel device 200b according to the illustrated exemplary embodiment is substantially similar to the pixel device 200a described with reference to FIGS. 4 through 6, except that bump pads 150 and lower insulation layer 140 are added.

The bump pads 150 may be formed on pixels P1, P2, P3, and P4 using a plating technology. Four bump pads 150 may be formed on each of the pixels P1, P2, P3, and P4. The bump pads 150 may be limitedly disposed on the pixels P1, P2, P3, and P4, but the inventive concepts are not limited thereto. For example, the bump pad 150 may be partially overlapped with a corresponding pixel.

A planarization layer 160 is formed so as to cover side surfaces of the bump pads 150. The planarization layer 160 is not particularly limited, but may be formed of, for example, an epoxy molding compound (EMC). The planarization layer 160 may fill a region between the pixels P1, P2, P3, and P4.

The lower insulation layer 140 may be disposed between a first intermediate layer 120 and the planarization layer 160, and a first layer L1 may be disposed on the lower insulation layer 140. The first layer L1 may be electrically connected to the bump pads 150 through the lower insulation layer 140.

According to the illustrated exemplary embodiment, the first layer L1 may be more stably formed by forming the bump pads 150 on the pixels P1, P2, P3, and P4. In the illustrated exemplary embodiment, it is described that the bump pads 150 are formed using the plating technology, and the first layer L1, the second layer L2, and pixel device pads 50g1 and 50r2 are formed thereon, but the bump pads 150 are not necessarily required. Instead of forming the bump pads 150 using the plating technology, a process may be simplified by forming interconnections using sputtering, electron beam evaporation, chemical vapor deposition, or the like.

FIG. 8 is a schematic cross-sectional view illustrating a pixel device 200c according to an exemplary embodiment.

Referring to FIG. 8, the pixel device 200c according to the illustrated exemplary embodiment is substantially similar to the pixel device 200a described with reference to FIGS. 4 through 6, except that the substrate 10 is not included. Accordingly, lower surfaces of pixels P1 through P4 may be exposed to a bottom surface of the pixel device 200c.

The pixels P1 through P4 may be held in a pixel holding insulator 260. The pixel holding insulator 260 covers side surfaces of the pixels P1 through P4 and holds the pixels P1 through P4 such that the pixels P1 through P4 are kept spaced apart from one another. The pixel holding insulator 260 may correspond to the above-described planarization layer. The pixel holding insulator 260 may be composed of a light-transmissive material, and may additionally include a contrast adjusting material so as to make it appear darker than a periphery, but the contrast adjusting material is not necessarily required.

Since a lower insulation layer 140, first and second intermediate layers 120 and 130, a first layer L1, a second layer L2, and pixel device pads 50r1, 50g1, 50b1, 50r2, 50g2, 50b2, 50c1, and 50c2 are substantially similar to those described with reference to FIGS. 4 through 6, or FIG. 7, detailed descriptions thereof will be omitted. In the illustrated exemplary embodiment, the first layer L1 is illustrated as being electrically connected to the pixel pads through the lower insulation layer 140, but as described with reference to FIG. 7, bump pads 150 may be formed first.

Although multi-pixel devices 200a, 200b, and 200c including four pixels have been described in the previous embodiments, the inventive concepts are not limited thereto. When the pixel device includes a plurality of pixels, the number of pixel device pads may be reduced to a smaller number than that of the pixel pads. Hereinafter, pixel device pads according to the number of pixels will be discussed with reference to multi-pixel devices 300a and 300b.

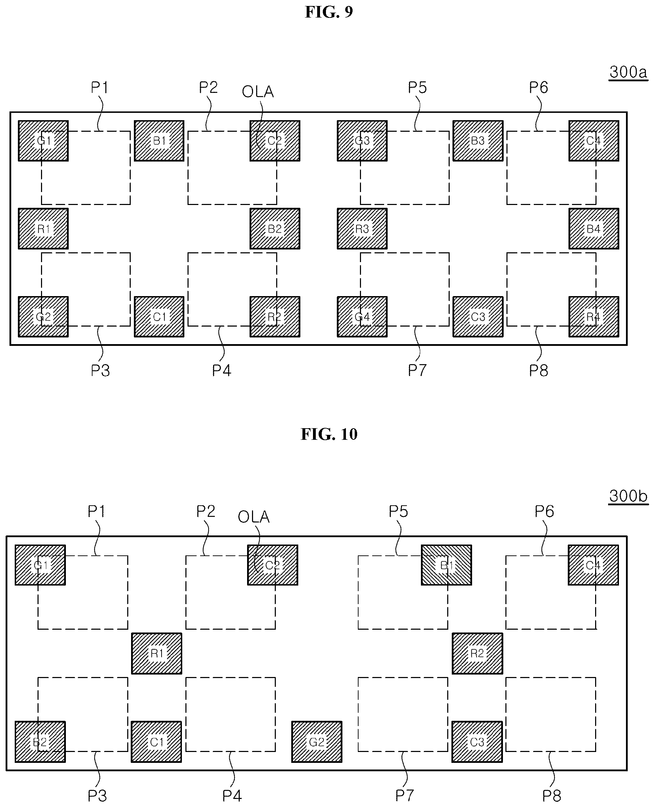

FIG. 9 is a schematic plan view illustrating the pixel device 300a according to an exemplary embodiment.

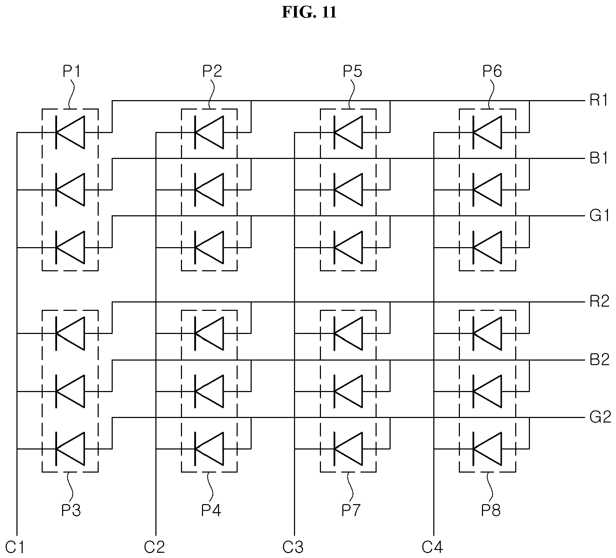

Referring to FIG. 9, the pixel device 300a according to the illustrated exemplary embodiment includes eight pixels P1 through P8. The pixels P1 through P4 are electrically connected to eight pixel device pads R1, G1, B1, R2, G2, B2, C1, and C2 as described with reference to FIG. 6, and the pixels P5 through P8 are similarly electrically connected to eight pixel device pads R3, G3, B3, R4, G4, B4, C3, and C4. Accordingly, 16 pixel device pads are provided for the 8 pixels P1 through P8, and the 8 pixels may be individually driven using these pixel device pads. That is, whenever 4 pixels are added, 8 pixel device pads may be added. However, the inventive concepts are not limited thereto, and the number of pixel device pads may be further reduced. This will be described with reference to FIG. 10 and FIG. 11.

FIG. 10 is a schematic plan view illustrating the pixel device 300b according to an exemplary embodiment, and FIG. 11 is a schematic circuit diagram of the pixel device 300b of FIG. 10.

Referring to FIG. 10 and FIG. 11, the pixel device 300b includes 8 pixels P1 through P8 and 10 pixel device pads R1, G1, B1, R2, G2, B2, C1, C2, C3, and C4. The pixels P1 through P8 are arranged in a 2×4 matrix, and four common pixel device pads C1, C2, C3, and C4 and six individual pixel device pads R1, G1, B1, R2, G2, and B2 are connected to light emitting diodes in the pixels P1 through P8. The eight pixels P1 through P8 may be individually driven by at least ten pixel device pads. Accordingly, in the pixel device 300b of the illustrated exemplary embodiment, the pixels may be driven using only six pixel device pads that are fewer than the number of pixels in the embodiment of FIG. 9, and thus a size of the pixel device pads may be further increased. Meanwhile, portions of the pixels are vertically overlapped with the pixel device pads, and the others may not be vertically overlapped with the pixel device pads.

According to the illustrated exemplary embodiment, light emitting diodes in the pixels P1, P2, P5, P6; or P3, P4, P7, P8 of a same row are electrically connected to three individual pixel device pads R1, G1, B1; or R2, B2, G2, and light emitting diodes in the pixels P1, P3; P2, P4; P5, P7; or P6, P8 in a same column are electrically connected to a single common pixel device pad C1, C2, C3, or C4.

Although an example including 8 pixels is described in the illustrated exemplary embodiment, the inventive concepts are not limited thereto. For example, the pixel device 200a may include pixels arranged in n positive integer rows and m positive integer columns. In this case, when each pixel includes four pixel pads, a total number of pixel pads becomes 4×n×m. The light emitting diodes in these pixels may be connected to 3×n individual pixel device pads and m common pixel device pads. That is, pixels arranged in an n×m matrix may be individually driven with only a minimum of (3×n + m) pixel device pads. In addition, more than the minimum number of pixel device pads may be formed if necessary, and when 8 pixel device pads are used in units of 4 pixels, approximately 2×n×m pixel device pads may be used. Accordingly, when the pixel device 200a includes pixels arranged in an n×m matrix, generally (3×n + m) or more and 2×n×m or less pixel device pads may be arranged to individually drive the light emitting diodes in all pixels.

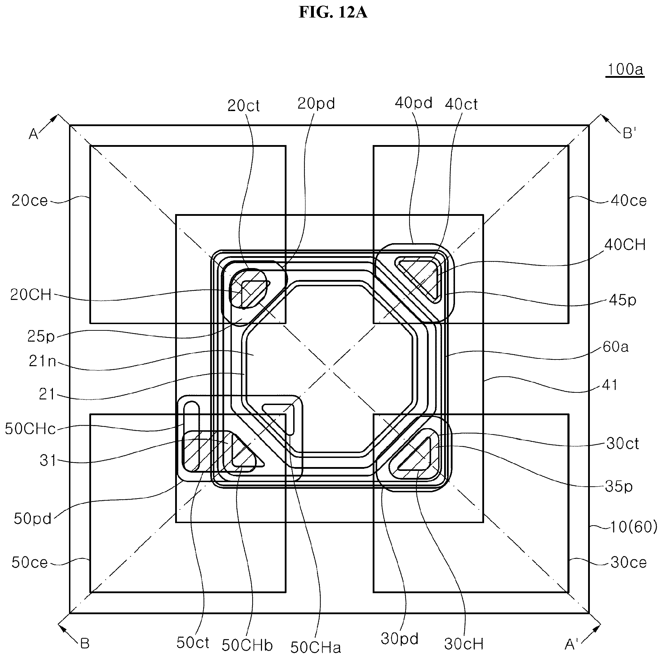

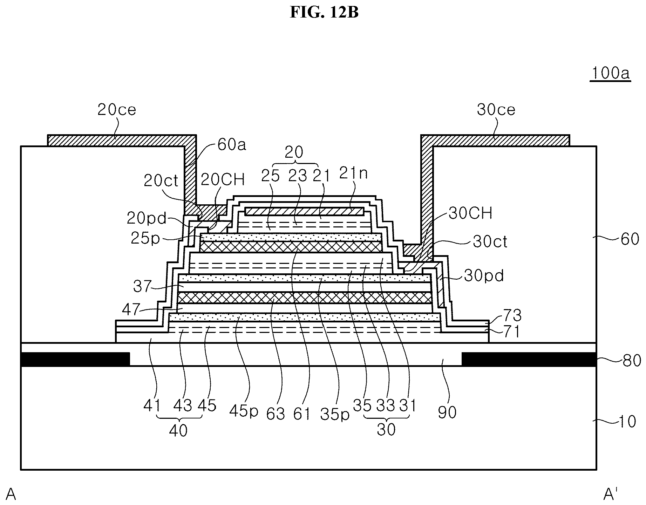

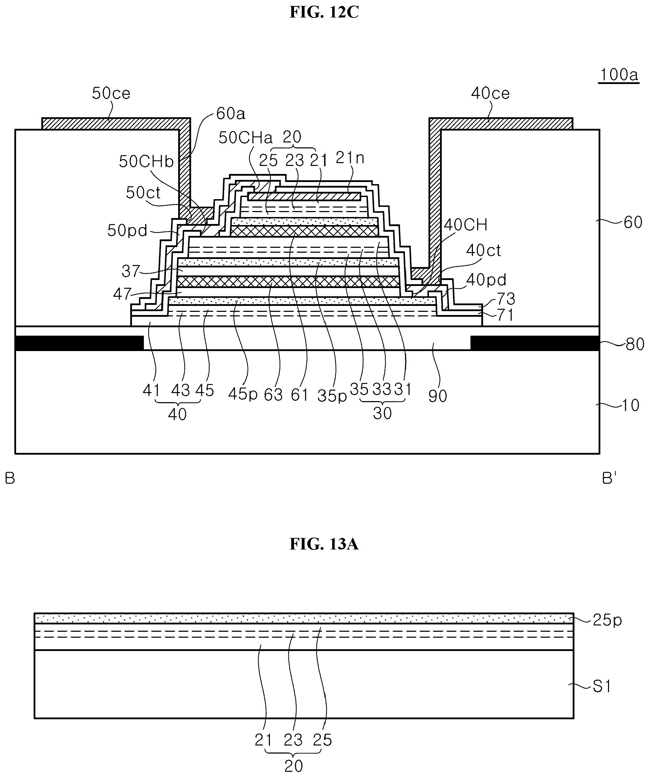

Hereinafter, as a more specific embodiment, the pixel device 100a will be described with reference to FIGS. 12A, 12B, and 12C, followed by a detailed description of a method of manufacturing the pixel device 100a. FIG. 12A is a schematic plan view illustrating the pixel device 100a according to an exemplary embodiment, and FIG. 12B and FIG. 12C are schematic cross-sectional views taken along lines A-A' and B-B' of its corresponding plan view shown in FIG. 12A, respectively.

Referring to FIGS. 12A, 12B, and 12C, the pixel device 100a may include a light emitting stacked structure, a first connection electrode 20ce, a second connection electrode 30ce, a third connection electrode 40ce, and a fourth connection electrode 50ce formed on the light emitting stacked structure, and each of the connection electrodes may be formed on a molding member 60.

The pixel device 100a may include a first LED sub-pixel, a second LED sub-pixel, and a third LED sub-pixel disposed on a substrate 10. The first LED sub-pixel may include a first light-emitting stack 20, the second LED sub-pixel may include a second light-emitting stack 30, and the third LED sub-pixel may include a third light-emitting stack 40. Although the drawings show the light emitting stacked structure including three light emitting stacks 20, 30, and 40, the inventive concepts are not limited to a particular number of light emitting stacks. For example, in some exemplary embodiments, the light emitting stacked structure may include two or more light emitting stacks therein. Herein, it will be exemplarily described that the pixel device 100a includes three light emitting stacks 20, 30, and 40 according to an exemplary embodiment.

A substrate 10 may include a light-transmissive insulating material so as to transmit light. However, in some exemplary embodiments, the substrate 10 may be translucent or partially transparent so as to transmit only light of a specific wavelength or only a portion of light of a specific wavelength. The substrate 10 may include glass, quartz, silicone, an organic polymer, or an organic-inorganic composite material, for example, silicon carbide (SiC), gallium nitride (GaN), indium gallium nitride ( InGaN), aluminum gallium nitride (AlGaN), aluminum nitride (AlN), gallium oxide (Ga₂O₃), and the like. A light blocking layer 80 defining a light emitting region is formed on the substrate 10, and a first adhesive layer 90 adheres the substrate 10 on which the light blocking layer 80 is formed and the light emitting stacked structure.

The first adhesive layer 90 may be composed of a light-transmissive material. However, for improving visibility of a display, it is also possible for the first adhesive layer 90 to include a light blocking material so as not to dispose an additional light blocking layer 80.

In cross section view, the light blocking layer 80 may be disposed around the light emitting stack in an upper region of the light emitting stack. The light blocking layer 80 may be disposed apart from the light emitting stack so as not to be overlapped vertically and laterally. However, the inventive concepts are not necessarily limited thereto, and to control a region or an area of a display pixel exposed to the outside, a region that is partially overlapped with the light emitting stack may be formed in the light blocking layer 80. In this case, the region that is partially overlapped vertically is formed in a direction from a region defining an outer periphery of the light emitting stack toward a center of the light emitting stack.

The first, second, and third light emitting stacks 20, 30, and 40 are configured so as to emit light towards the substrate 10. Accordingly, light emitted from the first light emitting stack 20 may pass through the second and third light emitting stacks 30 and 40. According to an exemplary embodiment, the first, second, and third light emitting stacks 20, 30, and 40 may emit light of different peak wavelengths from one another. In an exemplary embodiment, the light emitting stack disposed further away from the substrate 11 may reduce light loss by emitting light of a longer wavelength than the light emitting stack disposed close to the substrate 11. For example, the first light emitting stack 20 may emit red light, the second light emitting stack 30 may emit green light, and the third light emitting stack 40 may emit blue light.

In another exemplary embodiment, the second light emitting stack 30 may emit light having a shorter wavelength than that of the third light emitting stack 40. A portion of light emitted from the second light emitting stack 30 may be absorbed by the third light emitting stack 40. Accordingly, it is possible to reduce the luminous intensity of the second light emitting stack 30 and increase the luminous intensity of the third light emitting stack 40, and thus, it is possible to change a luminous intensity ratio of light emitted from the first, second and third light emitting stacks. For example, the first light emitting stack 20 may be configured to emit red light, the second light emitting stack 30 to emit blue light, and the third light emitting stack 40 to emit green light. Accordingly, it is possible to relatively decrease the luminous intensity of blue light and relatively increase the luminous intensity of green light, and thus, it is possible to easily adjust the luminous intensity ratio of red, green, and blue to be close to 3:6: 1. In an exemplary embodiment, light emitting areas of the first, second, and third light emitting stacks 20, 30, and 40 may be about 10,000um² or less, further, 4,000um² or less, and further, 2,500um² or less. In addition, the closer the light emitting stack is to the substrate 200, the larger the light emitting area may be, and by disposing the third light emitting stack 40 emitting green light closest to the substrate 200, the luminous intensity of green light may be further increased.

Hereinafter, the second light emitting stack 30 has been exemplarily described as emitting light having the shorter wavelength than that of the third light emitting stack 40, but it should be noted that the second light emitting stack 30 may emit light having the longer wavelength than that of the third light emitting stack 40, for example, green light.

The first light emitting stack 20 includes a first conductivity type semiconductor layer 21, an active layer 23, and a second conductivity type semiconductor layer 25. According to an exemplary embodiment, the first light emitting stack 20 may include, a semiconductor material emitting red light such as AlGaAs, GaAsP, AlGaInP, and GaP, without being limited thereto.

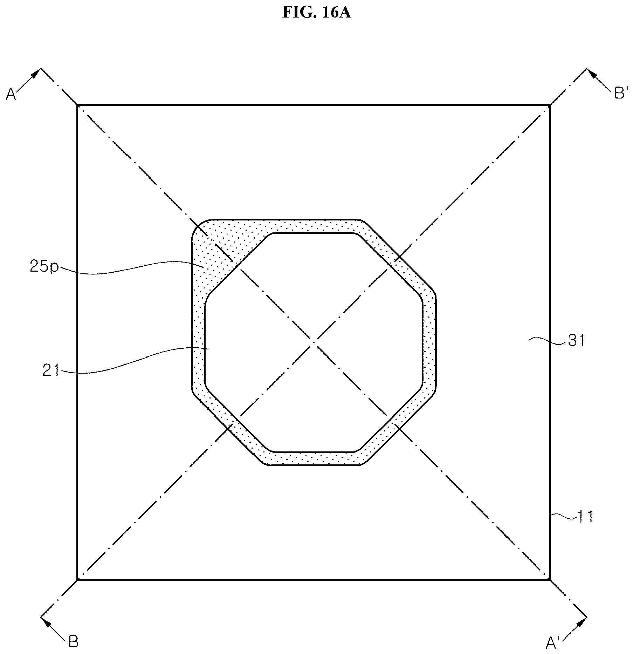

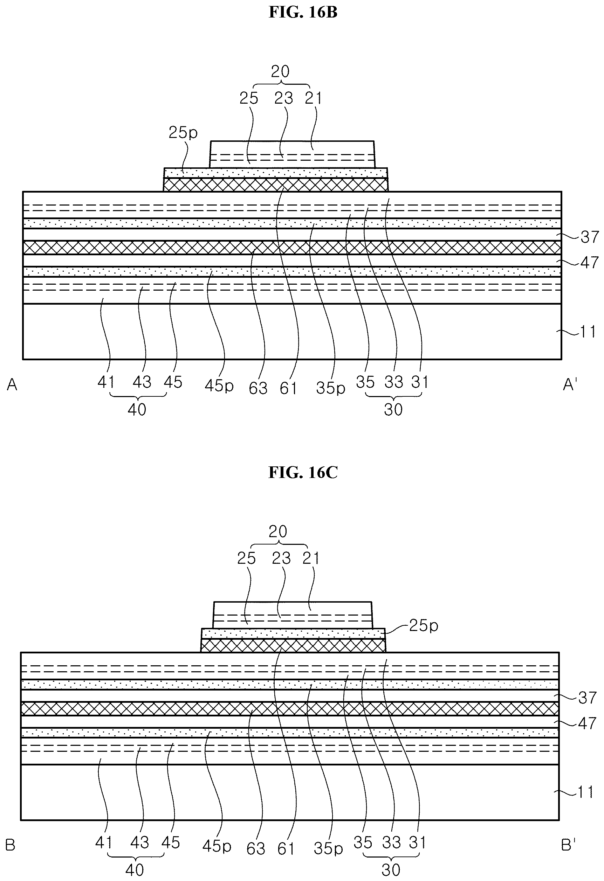

In an exemplary embodiment, the first light emitting stack 20 may have a symmetrical structure in plan view. For example, the first light emitting stack 20 may have an octagonal shape as shown in FIG. 12A. The symmetrical structure of the first light emitting stack 20 will be described in detail later with reference to FIGS. 16A, 16B, and 16C.

A first upper contact electrode 21n may be disposed on the first conductivity type semiconductor layer 21 and form an ohmic contact with the first conductivity type semiconductor layer 21. A first lower contact electrode 25p may be disposed under the second conductivity type semiconductor layer 25. According to an exemplary embodiment, a portion of the first conductivity type semiconductor layer 21 may be patterned to be recessed, and the first upper contact electrode 21n may be disposed in a recessed region of the first conductivity type semiconductor layer 21 so as to increase a level of ohmic contact. The first upper contact electrode 21n may have a single-layered structure or a multi-layered structure, and may include Al, Ti, Cr, Ni, Au, Ag, Sn, W, Cu, or an alloy thereof, for example, an Au-Te alloy or an Au-Ge alloy, without being limited thereto. In an exemplary embodiment, the first upper contact electrode 21n may have a thickness of about 100 nm, and may include a metal having a high reflectance so as to increase light emission efficiency in a downward direction toward the substrate 200.

The second light emitting stack 30 includes a first conductivity type semiconductor layer 31, an active layer 33, and a second conductivity type semiconductor layer 35. According to an exemplary embodiment, the second light emitting stack 30 may include a semiconductor material emitting blue light, such as GaN, InGaN, ZnSe, or the like, without being limited thereto. A second lower contact electrode 35p is disposed under the second conductivity type semiconductor layer 35 of the second light emitting stack 30.

The third light emitting stack 40 includes a first conductivity type semiconductor layer 41, an active layer 43, and a second conductivity type semiconductor layer 45. According to an exemplary embodiment, the third light emitting stack 40 may include a semiconductor material emitting green light, such as GaN, InGaN, GaP, AlGaInP, AlGaP, or the like. A third lower contact electrode 45p is disposed on the second conductivity type semiconductor layer 45 of the third light emitting stack 40.

According to an exemplary embodiment, each of the first conductivity type semiconductor layers 21, 31, and 41 and the second conductivity type semiconductor layers 25, 35, and 45 of the first, second, and third light emitting stacks 20, 30, and 40 may include a single-layered structure or a multi-layered structure, and in some exemplary embodiments, they may include a superlattice layer. Furthermore, the active layers 23, 33, and 43 of the first, second, and third light emitting stacks 20, 30, and 40 may have a single quantum well structure or a multi quantum well structure.

Each of the first, second, and third lower contact electrodes 25p, 35p, and 45p may include a transparent conductive material that transmits light. For example, the lower contact electrodes 25p, 35p, and 45p may include a transparent conductive oxide (TCO), for example, SnO, InO₂, ZnO, ITO, ITZO, or the like, without being limited thereto. The first lower contact electrode 25p may be thinner than the second and third lower contact electrodes 35p and 45p. For example, the first lower contact electrode 25p may be formed to have a thickness of about 240 nm, and the second and third lower contact electrodes 35p and 45p may be formed to have a thickness of about 300 nm.

A second adhesive layer 61 is disposed between the first light emitting stack 20 and the second light emitting stack 30, and a third adhesive layer 63 is disposed between the second light emitting stack 30 and the third light emitting stack 40. The first through third adhesive layers 90, 61, and 63 may include a non-conductive material that transmits light. For example, the first through third adhesive layers 90, 61, and 63 may include an optically clear adhesive (OCA), for example, epoxy, polyimide, SU8, spin-on-glass (SOG), benzocyclobutene (BCB), without being limited thereto.

A first adhesion enhancement layer 37 may be disposed between the third adhesive layer 63 and the second light emitting stack 30. For example, the first adhesive enhancement layer 37 may be disposed between the third adhesive layer 63 and the second lower contact electrode 35p to contact them. The first adhesion enhancement layer 37 may prevent the second light emitting stack 30 from being peeled off from the third adhesive layer 63 in a process involving a rapid stress change, such as a laser lift-off process, and furthermore, may prevent the second light emitting stack 30 from being cracked. The first adhesion enhancement layer 37 may be formed of, for example, a silicon oxide film, without being limited thereto.

A second adhesion enhancement layer 47 may be disposed between the third adhesive layer 63 and the third light emitting stack 40. For example, the second adhesive enhancement layer 47 may be disposed between the third adhesive layer 63 and the third lower contact electrode 45p to contact them. The second adhesion enhancement layer 47 may prevent the third light emitting stack 40 from being peeled off from the third adhesive layer 63 in a process involving a rapid stress change, such as a laser lift-off process, and furthermore, may prevent the third light emitting stack 40 from being cracked. The second adhesion enhancement layer 47 may be formed of, for example, a silicon oxide film, without being limited thereto.

The first and second adhesion enhancement layers 37 and 47 may have a thickness smaller than that of the second and third lower contact electrodes 35p and 45p, respectively, and may have a thickness of, for example, about 100 nm.

According to the illustrated exemplary embodiment, a first insulation layer 71 and a second insulation layer 73 are disposed on at least portions of sides of the first, second, and third light emitting stacks 20, 30, and 40. The first and second insulation layers 71 and 73 may include various organic or inorganic insulating materials, for example, polyimide, SiO₂, SiNx, Al₂O₃, or the like. For example, at least one of the first and second insulation layers 71 and 73 may include a distributed Bragg reflector DBR. As another example, at least one of the first and second insulation layers 71 and 73 may include a black organic polymer. In some exemplary embodiments, an electrically floating metallic reflection layer may be disposed on the first and second insulation layers 71 and 73 to reflect light emitted from the light emitting stacks 20, 30, and 40 toward the substrate 200. In some exemplary embodiments, at least one of the first and second insulation layers 71 and 73 may have a single-layered structure or a multi-layered structure formed of two or more insulation layers having different refractive indices from one another.

According to an exemplary embodiment, each of the first, second, and third light emitting stacks 20, 30, and 40 may be driven independently. More particularly, a common voltage may be applied to one of the first and second conductivity type semiconductor layers of each of the light emitting stacks, and a separate light emitting signal may be applied to another one of the first and second conductivity type semiconductor layers of each of the light emitting stacks. For example, according to an exemplary embodiment of the present disclosure, the first conductivity type semiconductor layers 21, 31, and 41 of each of the light emitting stacks may be n-type, and the second conductivity type semiconductor layers 25, 35, and 45 thereof may be p-type. In this case, the third light emitting stack 40 may have a stacked sequence that is reversed compared to those of the first light emitting stack 20 and the second light emitting stack 30, and accordingly, the p-type semiconductor layer 45 may be disposed over the active layer 43, so that a manufacturing process may be simplified. Hereinafter, according to the illustrated exemplary embodiment, the first conductivity type and the second conductivity type semiconductor layers may be expressed as n-type and p-type, respectively. Furthermore, the n-type and the p-type may be interchanged with each other.

The first, second, and third lower contact electrodes 25p, 35p, and 45p respectively connected to the p-type semiconductor layers 25, 35, and 45 of the light emitting stacks may be electrically connected to the first through third connection electrodes 20ce, 30ce, and 40ce, respectively, and receive a corresponding light emitting signal, respectively. Meanwhile, the n-type semiconductor layers 21, 31, and 41 of the light emitting stacks may be commonly electrically connected to the fourth connection electrode 50ce. Accordingly, the pixel device 100a has a common n-type light emitting stacked structure in which the n-type semiconductor layers 21, 31, and 41 of the first, second, and third light emitting stacks 20, 30 and 40 are commonly connected, and may be driven independently of one another. Since it has the common n-type light emitting stacked structure, sources of voltages applied to the first, second, and third light emitting stacks 20, 30, and 40 may be different from one another.

The pixel device 100a according to the illustrated exemplary embodiment has the common n-type structure, but the inventive concepts are not limited thereto. For example, in some exemplary embodiments, the first conductivity type semiconductor layers 21, 31, and 41 of each of the light emitting stacks may be p-type, and the second conductivity type semiconductor layers 25, 35, and 45 of each of the light emitting stacks may be n-type, and thus, it is possible to form a common p-type light emitting stacked structure. In addition, in some exemplary embodiments, the stacking sequence of each of the light emitting stacks is not limited to that illustrated in the drawings, but may be variously modified. Hereinafter, the pixel device 100a according to an exemplary embodiment of the present disclosure will be described with reference to the common n-type light emitting stacked structure.

According to the illustrated exemplary embodiment, the pixel device 100a includes a first pad 20pd, a second pad 30pd, a third pad 40pd, and a fourth pad 50pd. The first pad 20pd is electrically connected to the first lower contact electrode 25p through a first contact hole 20CH defined through the first insulation layer 71. The first connection electrode 20ce is electrically connected to the first pad 20pd through a first through hole 20ct defined through the second insulation layer 73. The second pad 30pd is electrically connected to the second lower contact electrode 35p through a second contact hole 30CH defined through the first insulation layer 71. The second connection electrode 30ce is electrically connected to the second pad 30pd through a second through hole 30ct defined through the second insulation layer 73.

The third pad 40pd is electrically connected to the third lower contact electrode 45p through a third contact hole 40CH defined through the first insulation layer 71. The third connection electrode 40ce is electrically connected to the third pad 40pd through a third through hole 40ct defined through the second insulation layer 73. The fourth pad 50pd is connected to the first conductivity type semiconductor layers 21, 31, and 41 of the first, second, and third light emitting stacks 20, 30, and 40 through a first sub-contact hole 50 CHa, a second sub-contact hole 50CHb, and a third sub-contact hole 50CHc defined through the first insulation layer 71 on the first conductivity type semiconductor layers 21, 31, and 41 of the first, second, and third light emitting stacks 20, 30, and 40. In particular, the first sub-contact hole 50CHa may expose the first upper contact electrode 21n, and the fourth pad 50pd may be connected to the first upper contact electrode 21n through the first sub-contact hole 50Cha. In this manner, the fourth pad 50pd may be electrically connected to the first conductivity type semiconductor layers 21, 31, and 41 through the sub-contact holes 50CHa, 50CHb and 50CHc, and thus, the manufacturing process of the pixel device 100a may be simplified. The fourth connection electrode 50ce is electrically connected to the fourth pad 50pd through a fourth through hole 50ct defined through the second insulation layer 73.

In the illustrated exemplary embodiment, although the first through fourth connection electrodes 20ce, 30ce, 40ce, and 50ce are illustrated and described as directly contacting the pads 20pd, 30pd, 40pd, and 50pd, respectively, the first through fourth connection electrodes 20ce, 30ce, 40ce, and 50ce may not be directly connected to the pads 20pd, 30pd, 40pd, and 50pd, and another connector may be interposed therebetween.

The first, second, third, and fourth pads 20pd, 30pd, 40pd, and 50pd are spaced apart and insulated from one another. According to an exemplary embodiment, each of the first, second, third, and fourth pads 20pd, 30pd, 40pd, and 50pd may cover at least portions of the sides of the first, second, and third light emitting stacks 20, 30, and 40. Through this, heat generated from the first, second, and third light emitting stacks 20, 30, and 40 may be easily dissipated.

The first through fourth connection electrodes 20ce, 30ce, 40ce, and 50ce may include a metal such as Cu, Ni, Ti, Sb, Zn, Mo, Co, Sn, Ag, or an alloy thereof, without being limited thereto.

The first through fourth connection electrodes 20ce, 30ce, 40ce, and 50ce may be formed on the planarization layer 60 covering an upper surface and side surfaces of the light emitting stack. To bond a light emitting device of an extremely small size such as a micro LED, a certain area of a bonding region needs to be secured. Since the first through fourth connection electrodes 20ce, 30ce, 40ce and 50ce are overlapped with a partial region of the light emitting stack, and extend to a region of the planarization layer 60 disposed outside of the light emitting stacked structure, a sufficient bonding region may be secured and the pixel device 100a may be stably mounted on the circuit board.

The planarization layer 60 may be formed of, for example, polyimide, PDMA or black epoxy molding compound (EMC). The first through fourth connection electrodes 20ce, 30ce, 40ce, and 50ce may be formed on the planarization layer 60. The planarization layer 60 may have an opening 60a exposing the first through fourth pads 20pd, 30pd, 40pd, and 50pd, and the first through fourth connection electrodes 20ce, 30ce, 40ce, and 50ce may be electrically connected to the first through fourth pads 20pd, 30pd, 40pd, and 50pd through the opening 60a. As show in FIG. 12B and FIG. 12C, the first through fourth connection electrodes 20ce, 30ce, 40ce, and 50ce may be connected to the first through fourth pads 20pd, 30pd, 40pd, and 60pd along a sidewall of the opening 60a. In the illustrated exemplary embodiment, it has been described that one opening 60a exposes the first through fourth pads 20pd, 30pd, 40pd, and 50pd, but the inventive concepts are not limited thereto. For example, the first through fourth pads 20pd, 30pd, 40pd, and 50pd may be exposed through different openings from one another.

The first through fourth connection electrodes 20ce, 30ce, 40ce, and 50ce may also be formed using a plating technology. For example, the first through fourth connection electrodes 20ce, 30ce, 40ce, and 50ce may be formed of a metallic layer that can be bonded to a circuit board through eutectic bonding, for example, Au or Au/In. In this case, a pad disposed on the circuit board may include, for example, In or Sn. It may be considered to form the first through fourth connection electrodes 20ce, 30ce, 40ce, and 50ce of In or Sn, but there are drawbacks that it is difficult to deposit In thickly through the plating technology, and it is hard to probe Sn for measuring electrical characteristics of the pixel device 100a. Accordingly, by forming the first through fourth connection electrodes 20ce, 30ce, 40ce, and 50ce of Au, a bonding metal layer having a sufficient thickness may be formed, and further, the electrical characteristics of the pixel device 100a may be easily measured.

Meanwhile, although not shown, a barrier layer may be interposed in the first through fourth connection electrodes 20ce, 30ce, 40ce, and 50ce. The barrier layer prevents a bonding material from being mixed into the light emitting stack and causing an electrical short during bonding.

When an emission area of the pixel is less than about 10,000 µm², or less than about 4,000 µm² or 2,500 µm², the connection electrodes 20ce, 30ce, 40ce, and 50ce may overlap a portion of at least one of the first, second, and third light emitting stacks 20, 30, and 40 as shown in the drawings. More particularly, the connection electrodes 20ce, 30ce, 40ce, and 50ce may overlap at least one step formed in a side surface of the light emitting stacked structure. As such, since an area of a lower surface of a connection electrode is greater than that of the upper surface thereof, a greater contacting area may be formed between the connection electrodes 20ce, 30ce, 40ce, and 50ce and the light emitting stacked structure. Accordingly, the connection electrodes 20ce, 30ce, 40ce, and 50ce may be more stably formed on the light emitting stacked structure, and heat generated in the light emitting stacked structure may be more efficiently dissipated to the outside.

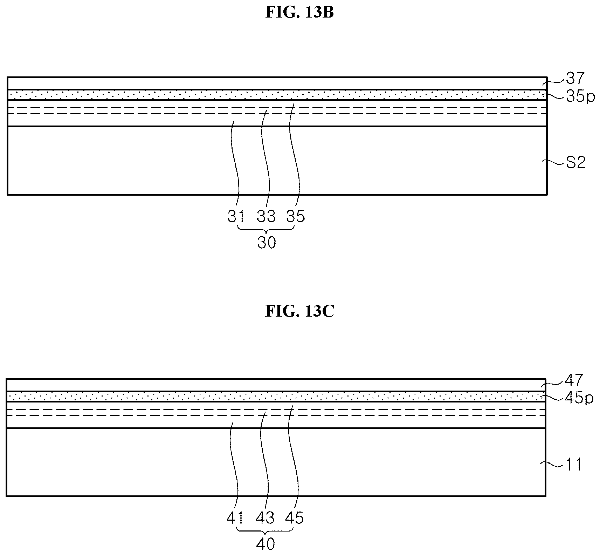

FIG. 13A is a schematic cross-sectional view illustrating a method of manufacturing a first LED sub-pixel of a unit pixel according to an exemplary embodiment, FIG. 13B is a schematic cross-sectional view illustrating a method of manufacturing a second LED sub-pixel of a unit pixel according to an exemplary embodiment, and FIG. 13C is a schematic cross-sectional view illustrating a method of manufacturing a third LED sub-pixel of a unit pixel according to an exemplary embodiment.

Referring to FIG. 13A, a first light emitting stack 20 is grown on a first temporary substrate S1. The first temporary substrate S1 may be, for example, a GaAs substrate. In addition, the first light emitting stack 20 is formed of AlGaInP-based semiconductor layers, and includes a first conductivity type semiconductor layer 21, an active layer 23, and a second conductivity type semiconductor layer 25. A first lower contact electrode 25p may be formed on the second conductivity type semiconductor layer 25.

Referring to FIG. 13B, a second light emitting stack 30 is grown on a second temporary substrate S2, and a second lower contact electrode 35p is formed on the second light emitting stack 30. The second light emitting stack 30 may include a first conductivity type semiconductor layer 31, an active layer 33, and a second conductivity type semiconductor layer 35.

The second temporary substrate S2 is a substrate capable of growing a gallium nitride-based semiconductor layer, and may be, for example, a sapphire substrate. The second light emitting stack 30 may be formed so as to emit blue light. Meanwhile, the second lower contact electrode 35p is in ohmic contact with the second conductivity type semiconductor layer 35. Furthermore, a first adhesion enhancement layer 37 may be formed on the second lower contact electrode 35p. The first adhesion enhancement layer 37 may be formed of, for example, SiO₂.

Referring to FIG. 13C, a third light emitting stack 40 is grown on a substrate 11, and a third lower contact electrode 45p is formed on the third light emitting stack 40. The third light emitting stack 40 includes a first conductivity type semiconductor layer 41, an active layer 43, and a second conductivity type semiconductor layer 45.

The substrate 11 is a substrate capable of growing a gallium nitride-based semiconductor layer, and may be, for example, a sapphire substrate. The third light emitting stack 40 may be formed so as to emit green light. The third lower contact electrode 45p is in ohmic contact with the second conductivity type semiconductor layer 45. Furthermore, a second adhesion enhancement layer 47 may be formed on the third lower contact electrode 45p. The second adhesion enhancement layer 47 may be formed of, for example, SiO₂.

The first conductivity type semiconductor layer 41, the active layer 43, and the second conductivity type semiconductor layer 45 of the third light emitting stack 40 may be sequentially grown on the substrate 11 by, for example, a metal organic chemical vapor deposition (MOCVD) method or a molecular beam epitaxy (MBE) method. The third lower contact electrode 45p may be formed on the second conductivity type semiconductor layer 45 by, for example, a physical vapor deposition method or a chemical vapor deposition method, and may include a transparent conductive oxide (TCO) such as SnO, InO₂, ZnO, ITO, or ITZO. When the third light emitting stack 40 according to an exemplary embodiment of the present disclosure emits green light, the substrate 11 may include Al₂O₃ (e.g., a sapphire substrate), and the third lower contact electrode 45p may include a transparent conductive oxide (TCO). The first and second light emitting stacks 20 and 30 may be similarly formed by sequentially growing the first conductivity type semiconductor layer, the active layer, and the second conductivity type semiconductor layer on the temporary substrates S1 and S2, respectively. The lower contact electrodes 25p and 35p including the transparent conductive oxide (TCO) may be formed on the second conductivity type semiconductor layers 25 and 35, respectively, by, for example, the physical vapor deposition method or the chemical vapor deposition method.

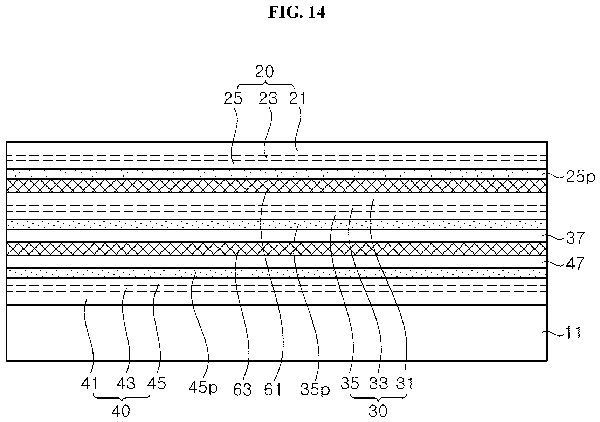

FIG. 14 is a schematic cross-sectional view illustrating a stacked structure of the pixel according to an exemplary embodiment. The stacked structure of the pixel is formed using the first through third LED sub-pixels described above with reference to FIGS. 13A, 13B, and 13C.

Referring to FIG. 14, first, the second light emitting stack 30 described with reference to FIG. 13B is bonded to the third light emitting stack 40 described with reference to FIG. 13C. For example, the first adhesion enhancement layer 37 and the second adhesion enhancement layer 47 may be bonded so as to face each other. A third adhesive layer 63 may be formed on the second adhesion enhancement layer 47, and the first adhesion enhancement layer 37 may be adhered to the third adhesive layer 63. The third adhesive layer 63 may be, for example, a transparent organic material layer or a transparent inorganic material layer. Examples of the organic layer include SU8, poly(methylmethacrylate) (PMMA), polyimide, parylene, benzocyclobutene (BCB), or the like, and examples of the inorganic layer include Al₂O₃, SiO₂, SiNx, or the like. The organic layers may be bonded under a high vacuum and a high pressure, and after surfaces thereof are planarized through, for example, chemical mechanical polishing, the inorganic layers may be bonded under a high vacuum by lowering a surface energy using plasma or the like.

Thereafter, the second temporary substrate S2 may be removed from the second light emitting stack 30 using a technique such as laser lift-off, chemical lift-off, or the like. In particular, the second temporary substrate S2 may be removed using the laser lift-off, and in this case, a sudden stress change may be induced in the second light emitting stack 30 and the third adhesive layer 63. The first and second adhesion enhancement layers 37 and 47 prevent the second light emitting stack 30 from being cracked or being peeled off from such a sudden stress change. Meanwhile, as the second temporary substrate S2 is removed, the first conductivity type semiconductor layer 31 of the second LED stack 30 is exposed upward. The exposed surface of the first conductivity type semiconductor layer 31 may be textured.

Subsequently, the first light emitting stack 20 is bonded to the second light emitting stack 30. In an exemplary embodiment, a second adhesive layer 61 may be formed on the first lower contact electrode 25p, and the first light emitting stack 20 may be coupled onto the second light emitting stack 30 using the second adhesive layer 61 . Since the second adhesive layer 61 is formed on the first lower contact electrode 25p, the second adhesive layer 61 may be formed on the first light emitting stack 20 while the second light emitting stack 30 and the third light emitting stack 40 are bonded, and thus, a process time may be shortened. However, the inventive concepts are not limited thereto, and the second adhesive layer 61 may be formed on the second light emitting stack 30, and the first light emitting stack 20 may be coupled to the second light emitting stack 30.

Thereafter, the first temporary substrate S 1 is removed. The first temporary substrate S 1 may be removed from the first light emitting stack 20 using, for example, an etching technique. Accordingly, the light emitting stacked structure shown in FIG. 14 is provided. The above-described pixel device 100a is formed by processing the light emitting stacked structure.

Hereinafter, a method of manufacturing the pixel device 100a using the light emitting stacked structure of FIG. 14 will be described in detail.

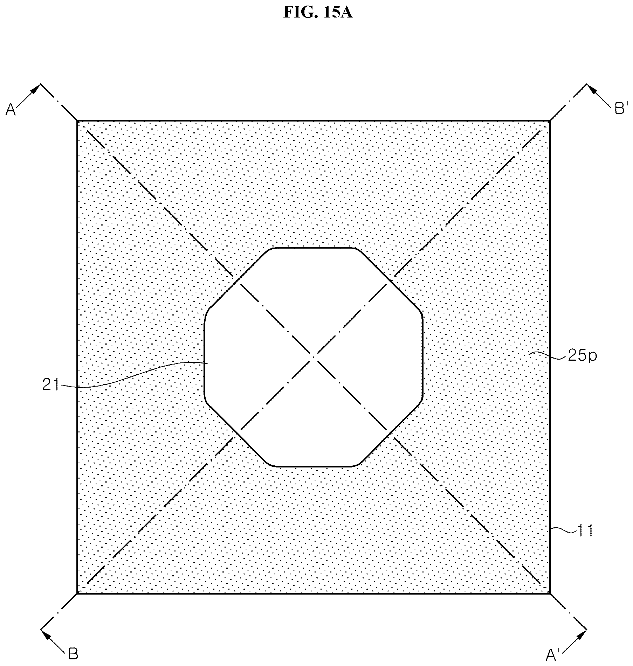

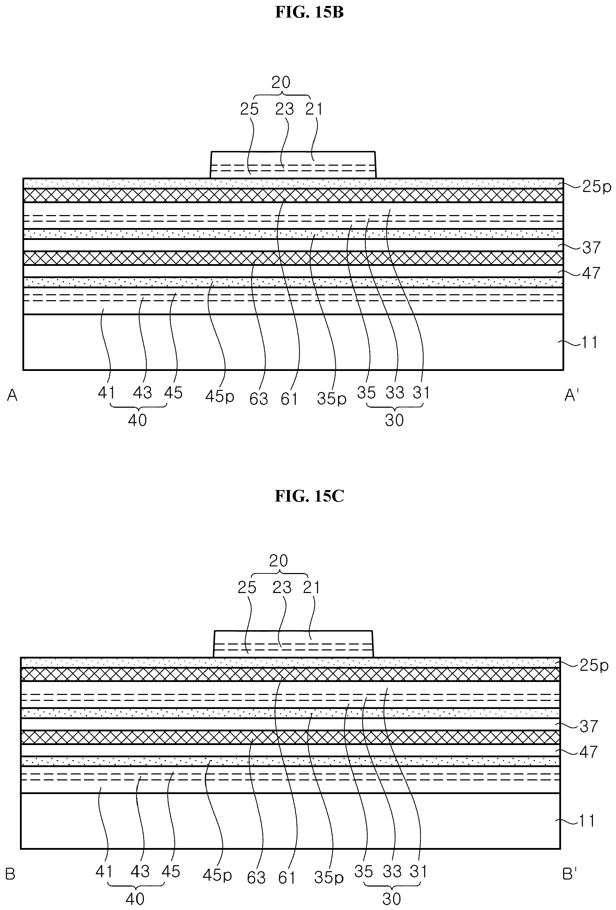

FIGS. 15A, 16A, 17A, 18A, 19A, 20A, 21A, 22A, 23A, 24A, and 25A are plan views illustrating a method of manufacturing a pixel device 100a according to an exemplary embodiment. FIGS. 15B, 16B, 17B, 18B, 19B, 20B, 21B, 22B, 23B, 24B, and 25B are cross-sectional views taken along line A-A' of its corresponding plan view shown in FIGS. 15A, 16A, 17A, 18A, 19A, 20A, 21A, 22A, 23A, 24A, and 25A. FIGS. 15C, 16C, 17C, 18C, 19C, 20C, 21C, 22C, 23C, 24C, and 25C are schematic cross-sectional views taken along line B-B' of its corresponding plan view shown in FIGS. 15A, 16A, 17A, 18A, 19A, 20A, 21A, 22A, 23A, 24A, and 25A.

First, referring to FIGS. 15A, 15B and 15C, the first lower contact electrode 25p is exposed by patterning the first conductivity type semiconductor layer 21, the active layer 23, and the second conductivity type semiconductor layer 25. The first conductivity type semiconductor layer 21, the active layer 23, and the second conductivity type semiconductor layer 25 may be patterned using photolithography and etching processes. The photolithography process may be performed using a first mask, and the first conductivity type semiconductor layer 21, the active layer 23, and the second conductivity type semiconductor layer 25 may be etched, for example, using a dry etching technique. After patterning, the first light emitting stack 20 surrounded by the exposed lower contact electrode 25p remains. Although one first light emitting stack 20 is illustrated herein, the first light emitting stack 20 may be patterned in each of unit pixel regions on the substrate 11.

The first light emitting stack 20 may be disposed in a central portion of the unit pixel region, without being limited thereto. Meanwhile, a planar shape of the first light emitting stack 20 may have a symmetrical structure. For example, the planar shape of the first light emitting stack 20 may have a symmetrical structure such as a mirror symmetrical structure or a rotational symmetrical structure. The pixel device 100a may have a rectangular or square shape, and the planar shape of the first light emitting stack 20 may have a mirror symmetrical structure with respect to a vertical plane passing through a straight line parallel to a lateral edge of the pixel device 100a and/ or a vertical plane passing through a straight line parallel to a vertical edge of the pixel 100a. The planar shape of the first light emitting stack 20 may have, for example, an octagonal, hexagonal, or rhombus shape, and further, may have a regular octagonal, regular hexagonal, or square shape, without being limited thereto.

Referring to FIGS. 16A, 16B, and 16C, the first lower contact electrode 25p is patterned such that a portion of the first lower contact electrode 25p remains around the first light emitting stack 20. The first lower contact electrode 25p may be patterned using a second mask. In this case, the second adhesive layer 61 may also be patterned together. Accordingly, the first conductivity type semiconductor layer 31 of the second light emitting stack 30 may be exposed around the first lower contact electrode 25p.

A planar shape of the first lower contact electrode 25p is substantially similar to that of the first light emitting stack 20, except that a protrusion (a portion where an indicator line of the reference number 25p touches) is included on one side of the first light emitting stack 20. The protrusion is disposed in a diagonal direction of the pixel device 100a . A region excluding the protrusion may have a shape substantially identical to the planar shape of the first light emitting stack 20. In a particular exemplary embodiment, the first lower contact electrode 25p may have a mirror symmetrical structure with respect to a vertical plane passing through line A-A', and may have an asymmetrical structure with respect to a vertical plane passing through line B-B'.

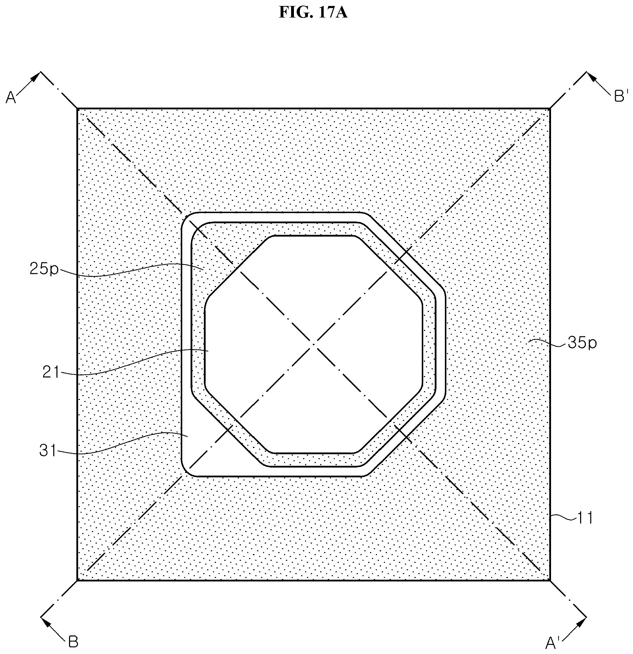

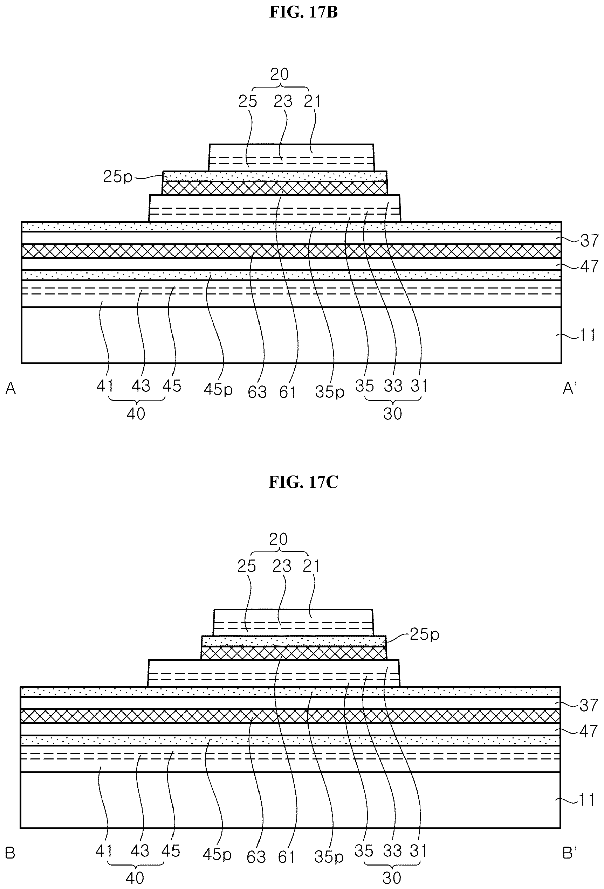

Referring to FIGS. 17A, 17B, and 17C, the second lower contact electrode 35p is exposed by patterning the first conductivity type semiconductor layer 31, the active layer 33, and the second conductivity type semiconductor layer 35. The first conductivity type semiconductor layer 31, the active layer 33, and the second conductivity type semiconductor layer 35 may be patterned using photolithography and etching processes. The photolithography process may be performed using a third mask, and the first conductivity type semiconductor layer 31, the active layer 33, and the second conductivity type semiconductor layer 35 may be etched using, for example, a dry etching technique. After patterning, the second light emitting stack 30 surrounded by the exposed second lower contact electrode 35p remains.

A planar shape of the second light emitting stack 30 is substantially similar to that of the first lower contact electrode 25p, except that a protrusion (a portion where an indicator line of the reference number 31 touches) is included on one side of the first lower contact electrode 25p. A region of the second light emitting stack 30 excluding the protrusion may have a shape substantially identical to the planar shape of the first lower contact electrode 25p. Accordingly, the second light emitting stack 30 has the shape substantially similar to the planar shape of the first light emitting stack 20, but has protrusions at two portions in the diagonal direction of the pixel device 100a . In a particular exemplary embodiment, the second light emitting stack 30 has a mirror symmetrical structure with respect to a vertical plane dividing an upper part from a lower part of the second light emitting stack 30, that is, the vertical plane passing through a straight line parallel to the lateral edge of the pixel device 100a . Except for the protrusion of the first lower contact electrode 25p and the protrusion of the second light emitting stack 30, the second light emitting stack 30 may have substantially the same planar shape as that of the first light emitting stack 20.

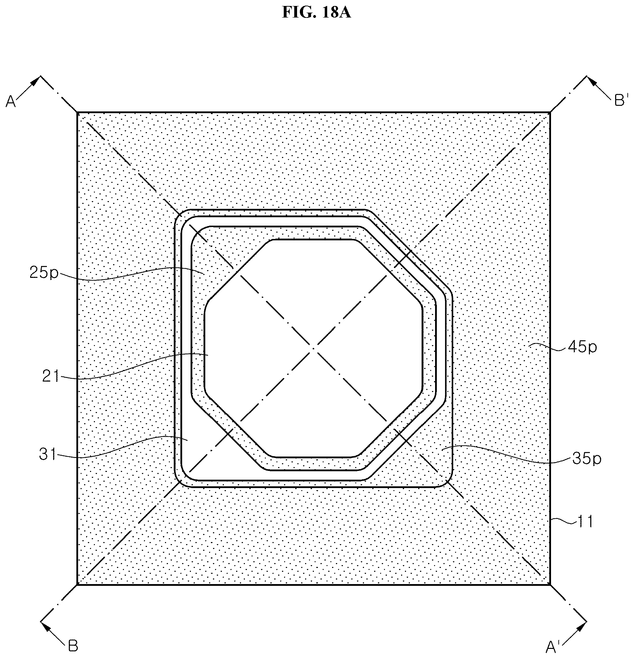

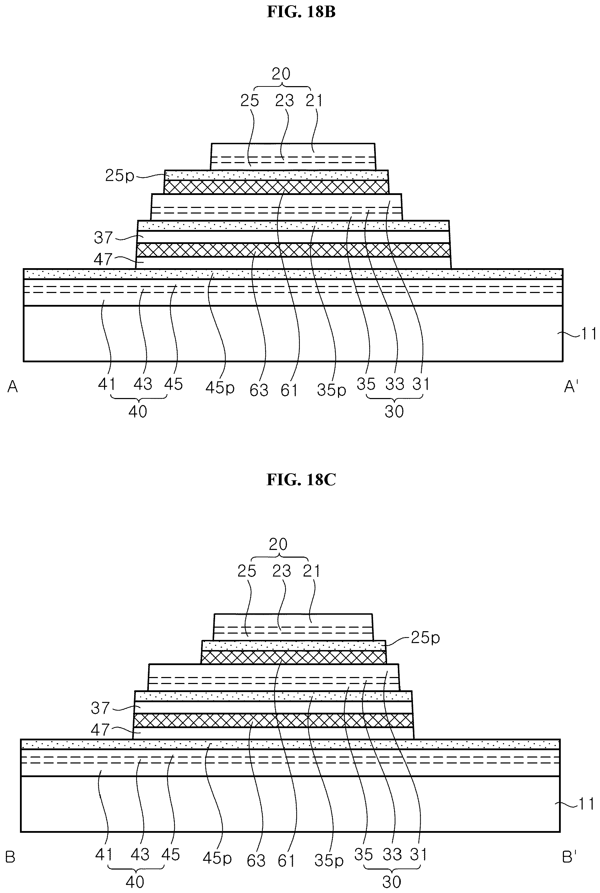

Referring to FIGS. 18A, 18B, and 18C, the second lower contact electrode 35p is patterned such that a portion of the second lower contact electrode 35p remains around the second light emitting stack 30. The second lower contact electrode 35p may be patterned using a fourth mask. In this case, the first adhesion enhancement layer 37, the third adhesive layer 63, and the second adhesion enhancement layer 47 may also be patterned together. Accordingly, the third lower contact electrode 45p may be exposed around the second lower contact electrode 35p.

A planar shape of the second lower contact electrode 35p is substantially similar to that of the second light emitting stack 30, except that a protrusion (a portion where an indicator line of the reference number 35p touches) is included on one side of the second light emitting stack 30. A region of the second lower contact electrode 35p excluding the protrusion may have a shape substantially identical to the planar shape of the second light emitting stack 30. In a particular exemplary embodiment, the second lower contact electrode 35p may have a mirror symmetrical structure with respect to the vertical plane passing through line B-B', and may have an asymmetrical structure with respect to the vertical plane passing through line A-A'.

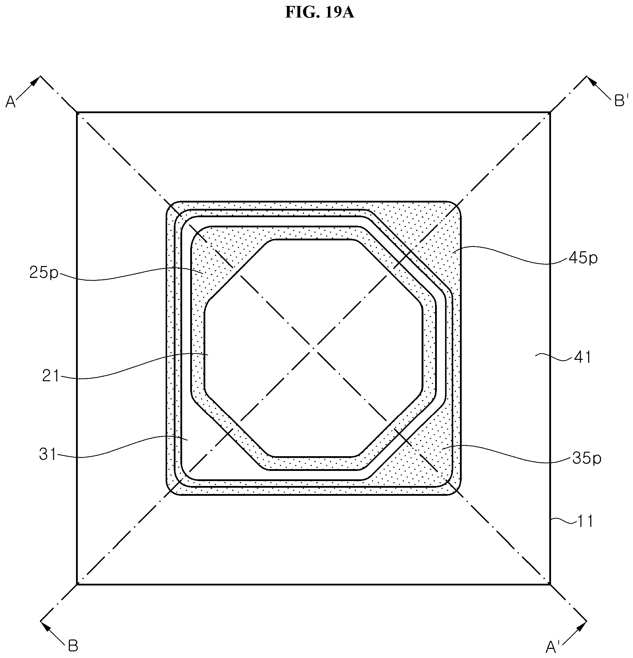

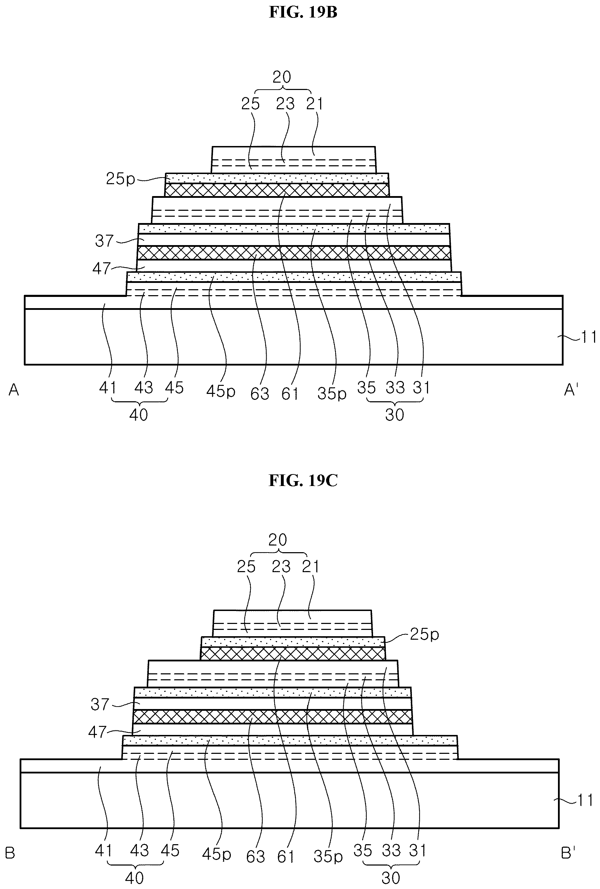

Referring to FIGS. 19A, 19B, and 19C, the third lower contact electrode 45p is patterned such that the third lower contact electrode 45p remains around the second lower contact electrode 35p. The third lower contact electrode 45p may be patterned using a fifth mask. Furthermore, the first conductivity type semiconductor layer 41 may be exposed by patterning the second conductivity type semiconductor layer 45 and the active layer 43. For example, the third lower contact electrode 45p, the second conductivity type semiconductor layer 45, and the active layer 43 may be etched using a dry etching technique. Accordingly, the first conductivity type semiconductor layer 41 is exposed around the third lower contact electrode 45p.

A planar shape of the third lower contact electrode 45p is substantially similar to that of the second lower contact electrode 35p, except that a protrusion (a portion where an indicator line of the reference number 45p touches) is included on one side of the second lower contact electrode 35p. A region of the third lower contact electrode 45p excluding the protrusion may have a shape substantially identical to the planar shape of the second lower contact electrode 35p. In a particular exemplary embodiment, the planar shape of the third lower contact electrode 45p may have a mirror symmetrical structure with respect to the vertical plane passing through line A-A', and may have an asymmetrical structure with respect to the vertical plane passing through line B-B'. Furthermore, the planar shape of the third lower contact electrode 45p may be substantially rectangular or square.

According to the illustrated exemplary embodiment, the first light emitting stack 20 has a smallest area among the light emitting stacks 20, 30, and 40. Meanwhile, the third light emitting stack 40 may have a largest area among the light emitting stacks 20, 30, and 40, and thus, a luminous intensity of the third light emitting stack 40 may be relatively increased.

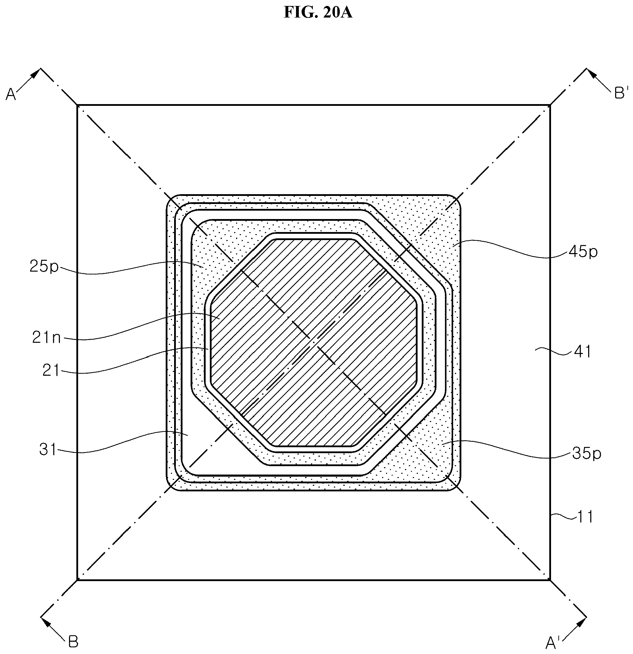

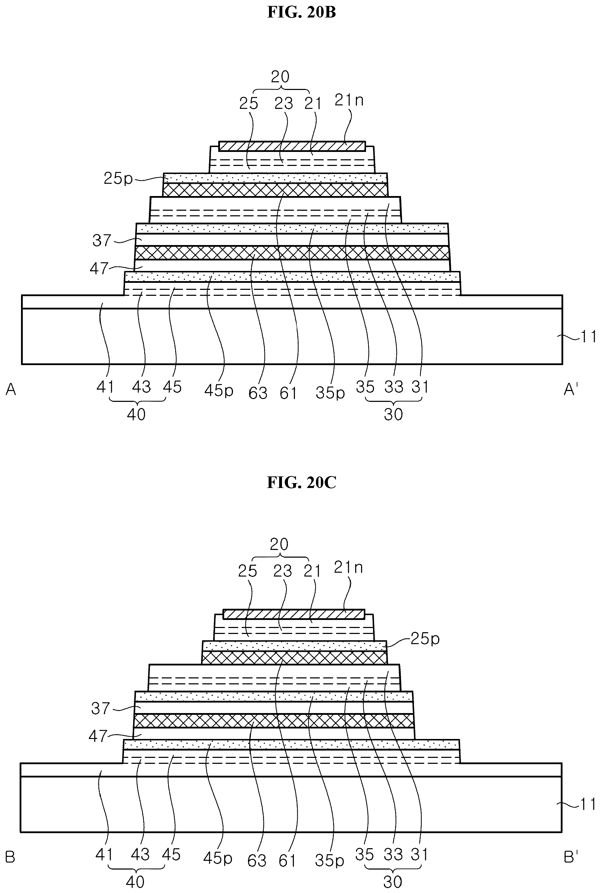

Referring to FIGS. 20A, 20B, and 20C, a portion of an upper surface of the first conductivity type semiconductor layer 21 of the first light emitting stack 20 may be patterned through wet-etching so as to form a first upper contact electrode 21n. The first conductivity type semiconductor layer 21 may be, for example, an n⁺⁺ GaAs layer, and a portion of an upper surface of the n⁺⁺ GaAs layer may be recessed through wet etching.

The first upper contact electrode 21n may be formed in a recessed region of the first conductivity type semiconductor layer 21. The first upper contact electrode 21n may be formed of, for example, AuGe/Ni/Au/Ti, and may have a thickness of, for example, 100 nm/25 nm/100 nm/10 nm. Ohmic contact characteristics may be improved by partially removing the surface of the n₊₊ GaAs layer and allowing the first upper contact electrode 21n to contact the first conductivity type semiconductor layer 21 in the recessed region.

The first upper contact electrode 21n may have an area smaller than that of the first light emitting stack 20. However, the first upper contact electrode 21n may have a planar shape substantially identical to that of the first light emitting stack 20.

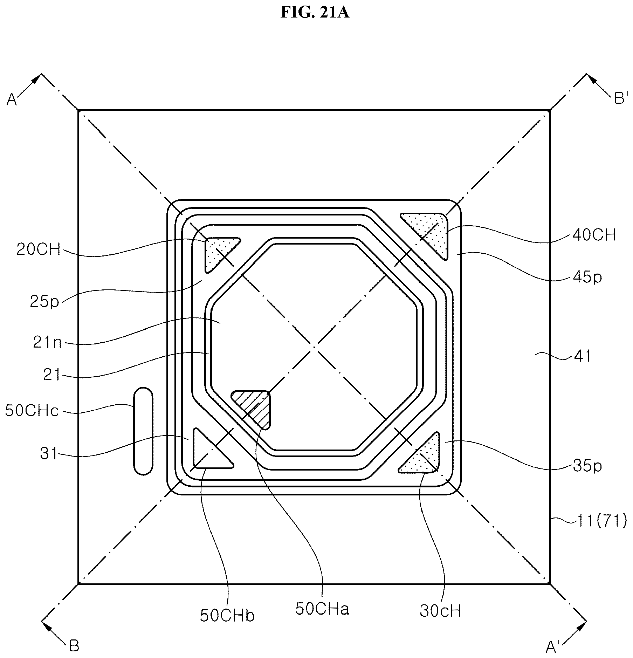

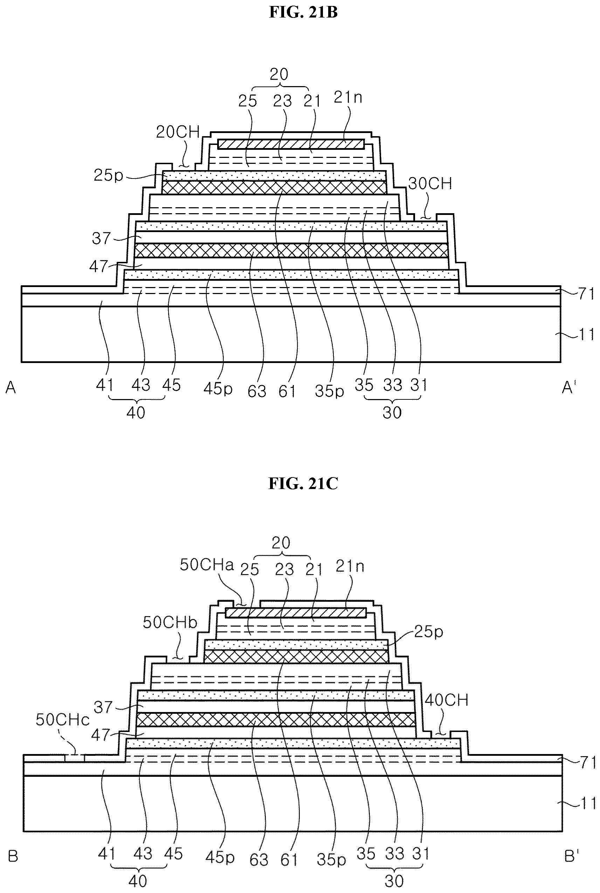

Referring to FIGS. 21A, 21B and 21C, a first insulation layer 71 covering the first through third light emitting stacks 20, 30, and 40 is formed. The first insulation layer 71 covers the first upper contact electrode 21n. The first insulation layer 71 may be formed of, for example, SiN, SiO₂, Al₂O₃, or the like to have a thickness of about 4000 Å.

Meanwhile, a portion of the first insulation layer 71 may be partially removed so as to form first, second, third, and fourth contact holes 20CH, 30CH, 40CH, and 50CH. The first contact hole 20CH is defined on the first lower contact electrode 25p to expose a portion of the first lower contact electrode 25p. The second contact hole 30CH may be defined on the second lower contact electrode 35p to expose the second lower contact electrode 35p. The third contact hole 40CH may be defined on the third lower contact electrode 45p to expose the third lower contact electrode 45p.

The fourth contact hole 50CH provides a path for allowing electrical connection to the first conductivity type semiconductor layers 21, 31, and 41 of the first through third light emitting stacks 20, 30, and 40. The fourth contact hole 50CH may include a first sub-contact hole 50CHa, a second sub-contact hole 50CHb, and a third sub-contact hole 50Chc. The first sub-contact hole 50CHa may be defined on the first conductivity type semiconductor layer 21 to expose a portion of the first upper contact electrode 21n, and the second sub-contact hole 50CHb may be defined on the first conductivity type semiconductor layer 31 to expose a portion of the first conductivity type semiconductor layer 31, and the third sub-contact hole 50CHc may be defined on the first conductivity type semiconductor layer 41 to expose a portion of the first conductivity type semiconductor layer 41.

The first contact hole 20CH, the second contact hole 30CH, the third contact hole 40CH, and the second sub-contact hole 50CHb may be disposed on the protrusions disposed at the outside of the first light emitting stack 20, respectively. Meanwhile, the first sub-contact hole 50Cha may be disposed on the first upper contact electrode 21n, and the third sub-contact hole 50CHc may be disposed on the first conductivity type semiconductor layer 41 at the outside of the third lower contact electrode 45p.

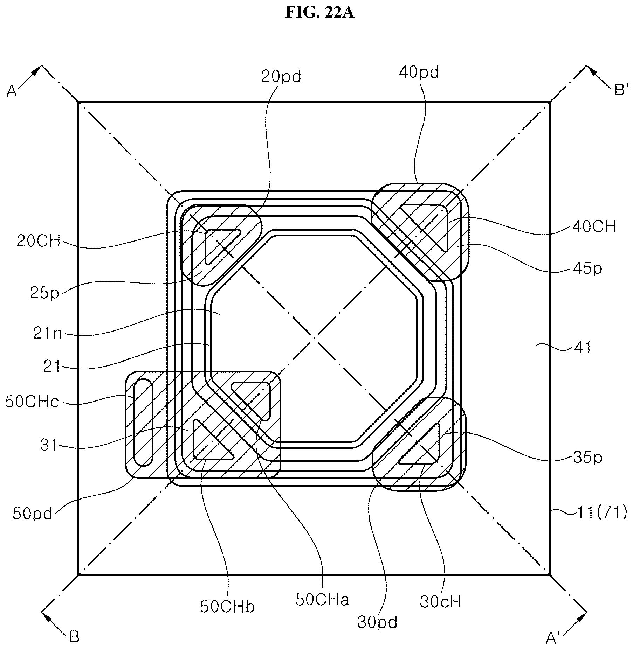

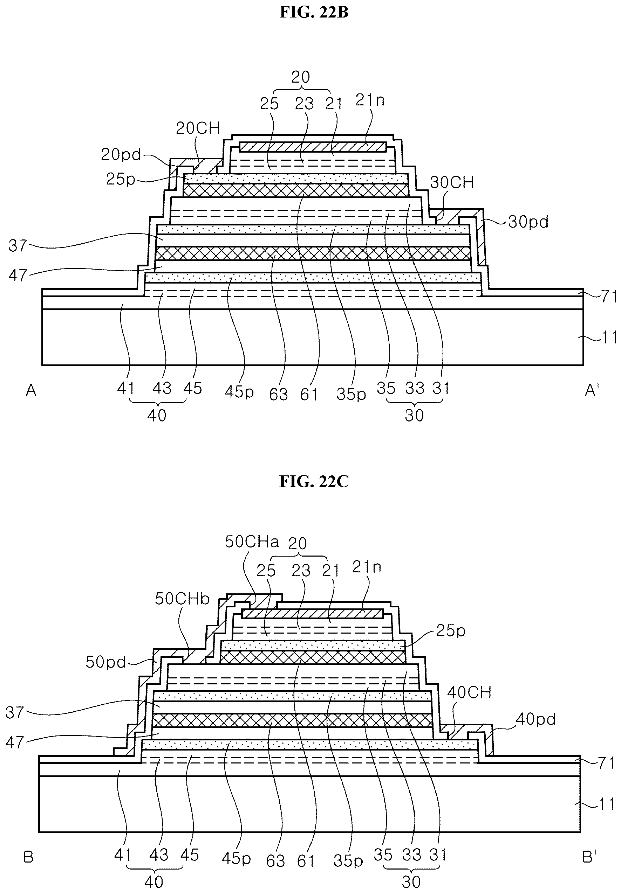

Referring to FIGS. 22A, 22B, and 22C, first, second, third, and fourth pads 20pd, 30pd, 40pd, and 50pd are formed on the first insulation layer 71. The first, second, third and fourth pads 20pd, 30pd, 40pd, and 50pd may be formed by, for example, forming a conductive layer on a substantially entire surface of the substrate 11 and patterning the conductive layer using photolithography and etching processes.

The first pad 20pd may be formed so as to overlap a region where the first contact hole 20CH is formed, and may be connected to the first lower contact electrode 25p through the first contact hole 20CH. The second pad 30pd may be formed so as to overlap a region where the second contact hole 30CH is formed, and may be connected to the second lower contact electrode layer 35p through the second contact hole 30CH. The third pad 40pd may be formed so as to overlap a region where the third contact hole 40CH is formed, and may be connected to the third lower contact electrode 45p through the third contact hole 40CH. The fourth pad 50pd may be formed so as to overlap a region in which the fourth contact hole 50CH is formed, in particular, a region in which the first, second, and third sub-contact holes 50CHa, 50CHb, and 50Chc are formed, and may be electrically connected to the first conductivity type semiconductor layers 21, 31, and 41 of the first through third light emitting stacks 20, 30, and 40.

The first through fourth pads 20pd, 30pd, 40pd, and 50pd may include Au, may be formed in, for example, a stacked structure of Ti/Ni/Ti/Ni/Ti/Ni/Au/Ti, and a thickness thereof may be, for example, about 100 nm/50 nm/100 nm/50 nm/100 nm/50 nm/3000 nm/10 nm.

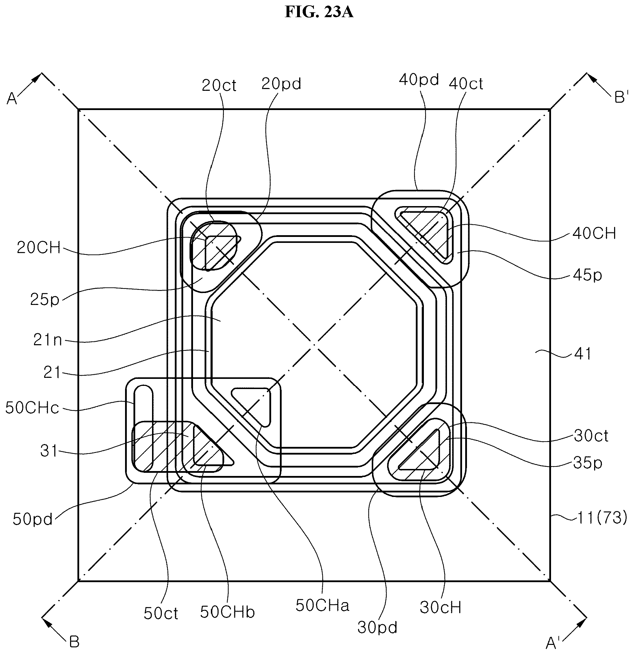

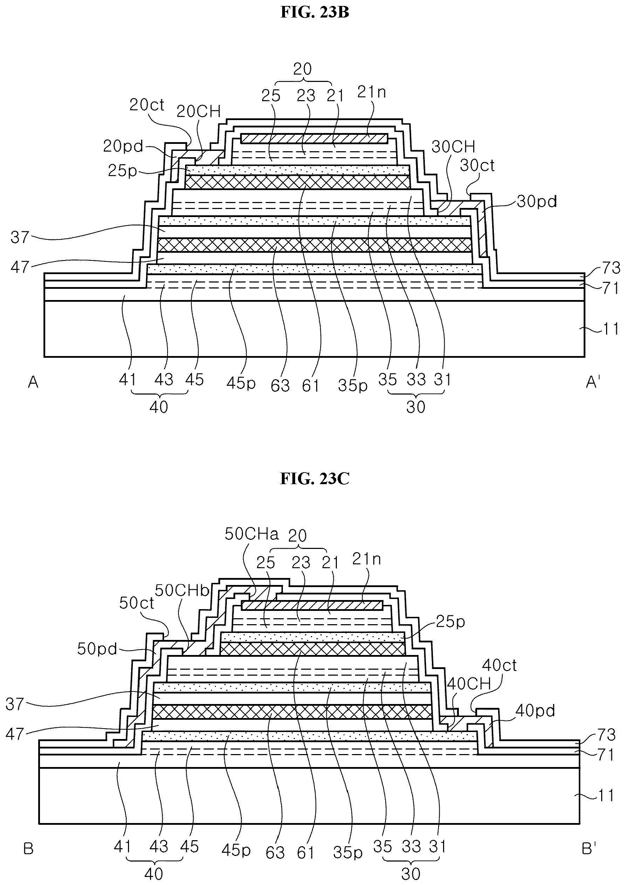

Referring to FIGS. 23A, 23B, and 23C, a second insulation layer 73 may be formed on the first insulation layer 71. The second insulation layer 73 may be formed of SiNx, SiO₂, Al₂O₃, or the like.

Subsequently, the second insulation layer 73 may be patterned to form first, second, third, and fourth through holes 20ct, 30ct, 40ct, and 50ct exposing the first through fourth pads 20pd, 30pd, 40pd, and 50pd.

The first through hole 20ct formed on the first pad 20pd exposes a portion of the first pad 20pd. The second through hole 30ct formed on the second pad 30pd exposes a portion of the second pad 30pd. The third through hole 40ct formed on the third pad 40pd exposes a portion of the third pad 40pd. The fourth through hole 50ct formed on the fourth pad 50pd exposes a portion of the fourth pad 50pd. In the illustrated exemplary embodiment, the first, second, third, and fourth through holes 20ct, 30ct, 40ct, and 50ct may be defined within regions in which the first, second, third, and fourth pads 20pd, 30pd, 40pd, and 50pd are formed, respectively. In addition, the first, second, third, and fourth through holes 20ct, 30ct, 40ct, and 50ct may be disposed at the outside of the first light emitting stack 20.

Subsequently, although not shown in the drawing, to form each pixel device 100a, a region is divided through an isolation process into individual device units, for example, pixel units, and isolated pixels are transferred to a temporary substrate, and a growth substrate 11 is removed.

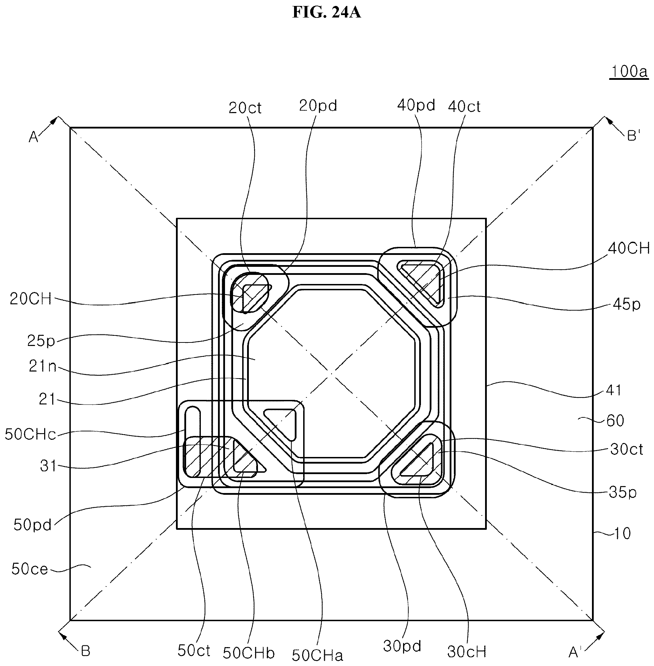

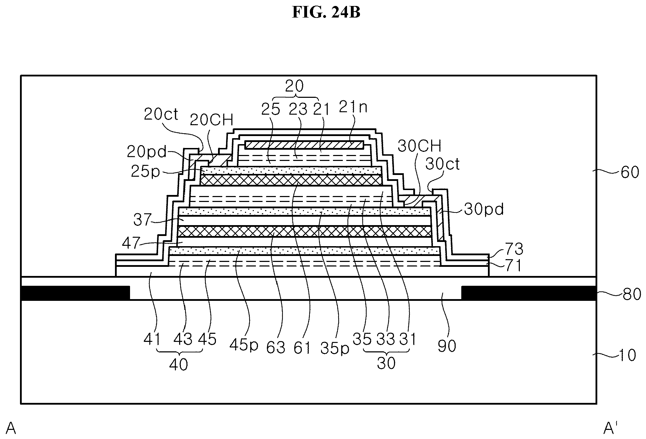

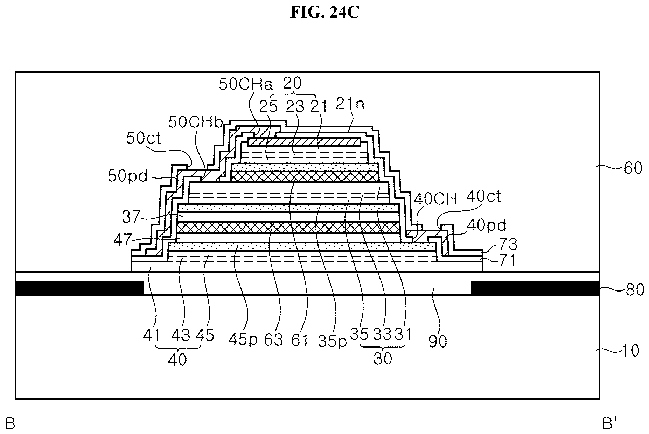

Referring to FIGS. 24A, 24B, and 24C, an additional transparent substrate 10 to be bonded to the pixels arranged on the temporary substrate is prepared. The transparent substrate 10 may be sapphire, glass, quartz, silicon, an organic polymer, or an organic-inorganic composite material, and the sapphire substrate will be described as an example. A light blocking layer 80 having a window defining a light emitting region is formed on the transparent substrate 10.

The light blocking layer 80 may be composed of an inorganic material or an organic material, and may be formed in a black color by adding a dye such as carbon. For example, it may include a material that absorbs light such as a black matrix. The light absorbing material may prevent light generated in the first through third light emitting stacks 20, 30, and 40 from being emitted to an undesired region, thereby improving a contrast of a display apparatus.

The light blocking layer 80 may have a window on a path of light such that light generated in the first through third light emitting stacks 20, 30, and 40 is incident on the transparent substrate 10. In an exemplary embodiment, the window may be defined as a region in which a portion of the light blocking layer 80 is opened. The window may be at least partially overlapped with the first through third light emitting stacks 20, 30, and 40 in a vertical direction. In addition, a width of the window may be wider than a width of corresponding first through third light emitting stacks 20, 30, and 40, but the inventive concepts are not limited thereto, and may be narrower than or equal to the width of the corresponding first through third light emitting stacks 20, 30, and 40.

A thickness of the light blocking layer 80 may be, for example, about 0.5um to about 2um, further may be about 0.5um to about 1.5um, and furthermore, may be about 0.5um to about 1um. When the light blocking layer 80 is as thin as 0.5um or less, it is difficult to achieve the purpose of blocking light, and when the thickness is larger than 2um, the pixel device 100a not only becomes thick, but a production cost may be increased due to an increase in the material used.

A first adhesive layer 90 may be used so as to attach the first through third light emitting stacks 20, 30, and 40 on the transparent substrate 10. The first adhesive layer 90 may be disposed on the transparent substrate 10, and may cover at least a portion of the light blocking layer 80. The first adhesive layer 90 may be formed on an entire surface of the transparent substrate 10, without being limited thereto, and may be formed in a partial region so as to expose a region near an edge of the transparent substrate 10. The first adhesive layer 90 may fill the windows formed by the light blocking layer 80.

Pixels including the first through third light emitting stacks 20, 30, and 40 are adhered to the window region defined by the light blocking layer 80. A plurality of window regions may be disposed on the transparent substrate 10, and the pixels may be adhered to each of the window regions. The pixels formed on the substrate 11 may be divided and arranged on a plurality of transparent substrates 10, and the pixels may be arranged on the transparent substrate 10 at gaps wider than those arranged on the substrate 11.

Meanwhile, a planarization layer 60 covering the first through third light emitting stacks 20, 30, and 40 is formed. The planarization layer 60 may be formed on the entire surface of the transparent substrate 10, and may cover upper surfaces and side surfaces of the first through third light emitting stacks 20, 30, and 40.

In an exemplary embodiment, the planarization layer 60 may be formed of an inorganic material or an organic material, and may be formed in a black color by adding a dye such as carbon. For example, the planarization layer 60 may be formed using a molding technology, and may include a material that absorbs light, such as a black matrix, or may be transparent.

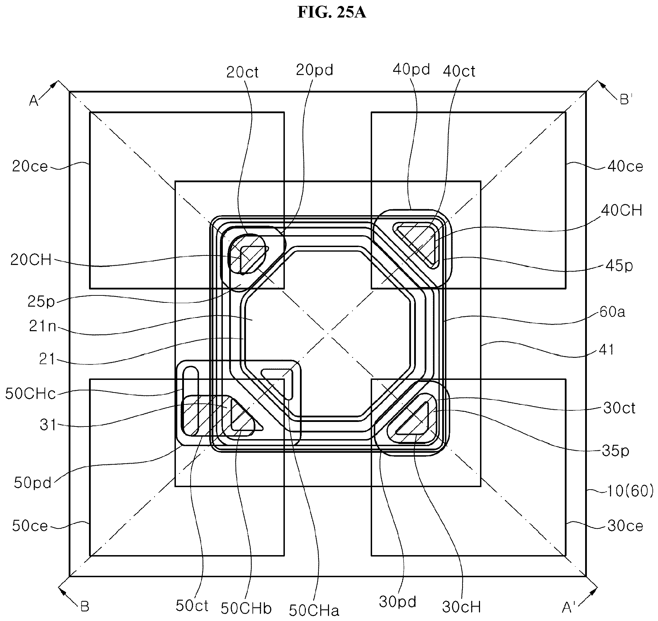

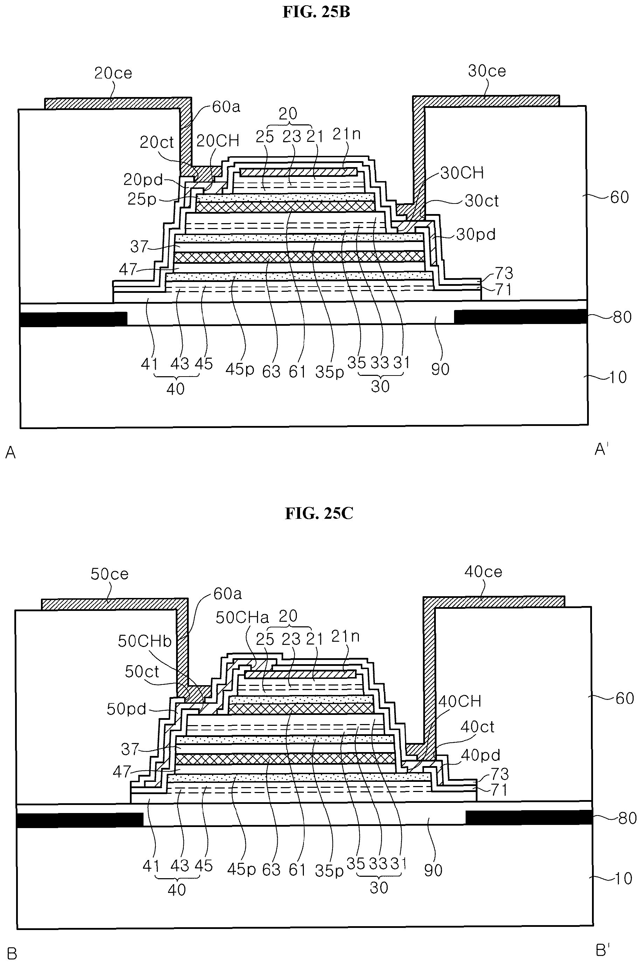

Referring to FIGS. 25A, 25B, and 25C, a partial region of the planarization layer 60 is removed to form an opening 60a exposing the first, second, third, and fourth through holes 20ct, 30ct, 40ct, and 50ct. Although it has been described that the opening 60a is formed after the planarization layer 60 is formed, the inventive concepts are not limited thereto, and the opening 60a may be formed together while the planarization layer 60 is formed. The first through fourth pads 20pd, 30pd, 40pd, and 50pd are exposed through the opening 60a.

Subsequently, first, second, third, and fourth connection electrodes 20ce, 30ce, 40ce, and 50ce are formed on the planarization layer 60. The first connection electrode 20ce may be formed so as to overlap a region in which the first through hole 20ct is formed, and may be connected to the first pad 20pd through the first through hole 20ct. The second connection electrode 30ce may be formed so as to overlap a region where the second through hole 30ct is formed, and may be connected to the second pad 30pd through the second through hole 30ct. The third connection electrode 40ce may be formed so as to overlap a region in which the third through hole 40ct is formed, and may be connected to the third pad 40pd through the third through hole 40ct. The fourth connection electrode 50ce may be formed so as to overlap a region where the fourth through hole 50ct is formed, and may be connected to the fourth pad 50pd through the fourth through hole 50ct.

Since the connection electrode extends with a step rather than extends laterally from the pad to an outer end of the connection electrode, a length of a metallic material can be formed to be long, so that extraction efficiency by light reflection may be improved and it is effective for heat dissipation.

The first, second, third, and fourth connection electrodes 20ce, 30ce, 40ce, and 50ce may be spaced apart from one another and may be formed so as to be partially overlapped with the light emitting stacked structure. The first, second, third, and fourth connection electrodes 20ce, 30ce, 40ce, and 50ce are electrically connected to the first, second, third, and fourth pads 20pd, 30pd, 40pd, and 50pd, respectively, to transmit an external signal to each of the light emitting stacks 20, 30, and 40. The first, second, third, and fourth connection electrodes 20ce, 30ce, 40ce, and 50ce are formed along an inner surface and an upper surface of the planarization layer 60, and may be formed in a step shape. The ends of the first, second, third, and fourth connection electrodes 20ce, 30ce, 40ce, and 50ce disposed on the upper surface of the planarization layer 60 may be recessed inwardly than an outer surface of the planarization layer 60, that is, may be recessed from the outer surface of the first, the second, third, and fourth connection electrodes 20ce, 30ce, 40ce, and 50ce to a central portion of the light emitting stack.

Although not shown, after the first, second, third, and fourth connection electrodes 20ce, 30ce, 40ce, and 50ce are formed, as described with reference to FIG. 3, a protection layer 110 may be additionally formed.

Thereafter, an individualized pixel device 100a can be completed by dividing the transparent substrate 10 into pixel device units. The transparent substrate 10 may be divided using laser scribing technology. In the illustrated exemplary embodiment, the pixel device 100a has been described as a unit pixel device including one pixel, but a multi-pixel device may be manufactured by dividing the transparent substrate 10 so as to include a plurality of pixels. In addition, in the case of the multi-pixel device, to reduce the number of pixel device pads, instead of the first, second, third, and fourth connection electrodes 20ce, 30ce, 40ce, and 50ce, for example, a first layer L1, a second layer L2, and pixel device pads 50r1, 50g1, 50b1, 50r2, 50g2, 50b2, 50c1, and 50c2 may be formed as described above with reference to FIGS. 4 through 6.

The pixel devices 100a may be bonded onto the circuit board 1001 or the pixel substrate 2100 of FIG. 1 using the first, second, third, and fourth connection electrodes 20ce, 30ce, 40ce, and 50ce, and thus, a display apparatus 10000 may be provided. The pixel devices 100a may be bonded such that the substrate 10 is disposed on a user's side in the display apparatus 10000, and light emitted from the first light emitting stack 20, the second light emitting stack 30, and the third light emitting stack 40 may be emitted to the outside through the transparent substrate 10.

According to the illustrated exemplary embodiment, by manufacturing the pixels including the first through third light emitting stacks 20, 30, and 40 on the substrate 11 separately from the transparent substrate 10, a smaller number of pixels on the substrate 11 are manufactured more, and thus, a production amount of pixel devices may be increased, and production costs may be reduced.

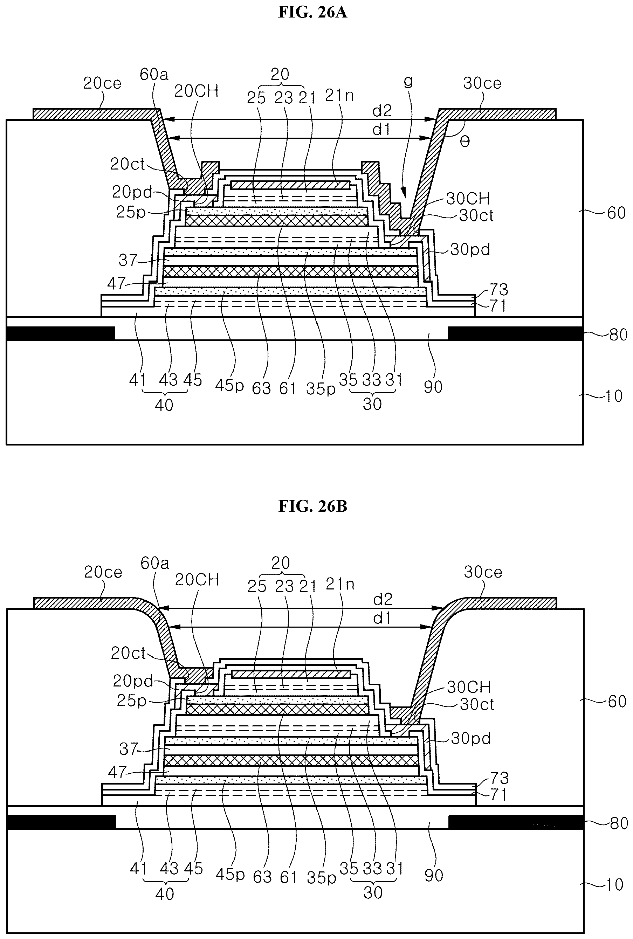

As shown in FIG. 26A, the inner surface of the planarization layer 60 may include an inclined side surface. Accordingly, at least one of the first, second, third, and fourth connection electrodes 20ce, 30ce, 40ce, and 50ce may include an inclined side surface along the inner surface of the planarization layer 60, and distances d1 and d2 between the connection electrodes formed on the inner surface may increase as a distance from the light emitting stack increases. The planarization layer 60 and the connection electrode formed along the side surface of the light emitting stack may form a groove g. A bottom surface of the groove g may be formed toward a light exiting direction. The connection electrode disposed on the inner surface of the planarization layer 60 and the upper surface of the planarization layer 60 may be connected to include a predetermined angle θ, in which the angle θ may be formed at an angle greater than 90°. Accordingly, since lights emitted toward a direction of the circuit board among lights generated in the light emitting stack may be reflected by the inclined side surface of the connection electrode and reflected upward, light extraction efficiency may be improved.

As shown in FIG. 26B, the inner surface of the planarization layer 60 may include a flat surface and a curved surface. In the cross-sectional view of FIG. 26B, a planar region is indicated by a linear shape, and a curved region is indicated by a curved line. The upper surface and the inner surface of the planarization layer 60 may be connected with a curved surface. Therefore, the connection electrode disposed on the upper surface of the planarization layer 60 and the connection electrode disposed on the inner surface of the planarization layer 60 may also include a planar region and a curved region, and are indicated by a linear line and a curved line in cross-section view. In particular, since the connection electrode is formed as a curved surface at a corner connected from the upper surface to the inner surface of the planarization layer 60, it is possible to prevent deterioration of the visibility of the display due to a glare in a corner region.

FIG. 27 is a schematic cross-sectional view illustrating a pixel module having pixel devices according to an exemplary embodiment.

Referring to FIG. 27, pixel devices 100a may be disposed on a circuit board 1001 such that connection electrodes are electrically connected to the circuit board. Herein, since the pixel devices 100a are same as those described with reference to FIGS. 12A, 12B, and 12C, a detailed description thereof is omitted to avoid redundancy.

As shown in FIG. 27, the connection electrodes may be bonded to pads 1003 on the circuit board 1001 through a bonding material 1005. A gap between the pads 1003 on the circuit board 1001 may be greater than a gap between the connection electrodes. Meanwhile, the bonding materials 1005 may have a larger gap between lower surfaces than a gap between upper surfaces.

One surface of the connection electrode on which the connection electrode faces the circuit board 1001 may be formed so as to be closer to the circuit board 1001 than one surface of the light emitting stack on which the light emitting stack faces the circuit board. In addition, a height difference h1 between one surface of the connection electrode and one surface of the light emitting stack may be smaller than a total height h2 of the light emitting stack. Accordingly, a thin pixel module may be formed.

A molding layer 1007 covering a plurality of pixel devices may be formed over the pixel module in which the plurality of pixel devices 100a is arrayed. The molding layer 1007 is not particularly limited as long as it is a light-transmissive material. A thickness m1 of the pixel device 100a may be smaller than a distance m2 from an upper surface of the molding layer 1007 to an upper surface of the pixel device 100a in contact with the molding layer. Also, the height h2 of the light emitting stack may be smaller than the distance m2 from the upper surface of the molding layer 1007 to the upper surface of the pixel device 100a in contact with the molding layer 1007. Accordingly, the pixel module and the display apparatus can be made thinner, and thus, a distance between the user's eyes and the pixel device 100a may be reduced when viewed from the outside, thereby further improving visibility.

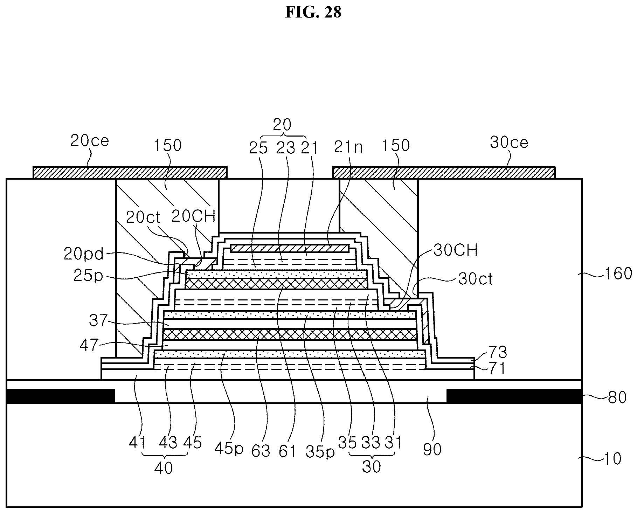

FIG. 28 is a schematic cross-sectional view illustrating a pixel device 100b according to an exemplary embodiment.

Referring to FIG. 28, the pixel device 100b according to the illustrated exemplary embodiment is substantially similar to the pixel device 100a described with reference to FIGS. 12A, 12B, and 12C, except that connection electrodes 20ce, 30ce, 40ce, and 50ce are electrically connected to first through fourth pads 20pd, 30pd, 40pd, and 50pd through bump pads 150 formed using a plating technology.

After pixels are attached to a transparent substrate 10, the bump pads 150 may be formed using a plating technology, and a planarization layer 160 may be formed so as to cover side surfaces of the bump pads 150. Thereafter, the connection electrodes 20ce, 30ce, 40ce, and 50ce may be formed on the planarization layer 160 to be connected to the bump pads 150. Subsequently, the transparent substrate 10 may be divided into individual pixel devices and the pixel device 100b may be manufactured.

Although the pixel devices 100a and 100b described in the previous embodiment are unit pixel devices having a single pixel, a multi-pixel device may be manufactured by dividing the transparent substrate 10 so as to include a plurality of pixels. In the case of the multi-pixel device, as described with reference to FIGS. 4 through 11, the number of pixel device pads may be reduced to be smaller than the number of pixel pads through an additional process. Hereinafter, as an example, a method of configuring the circuit of FIG. 6 will be briefly described.

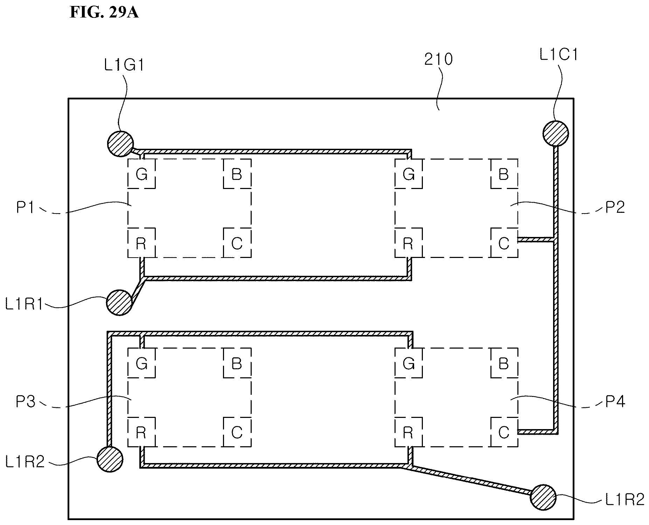

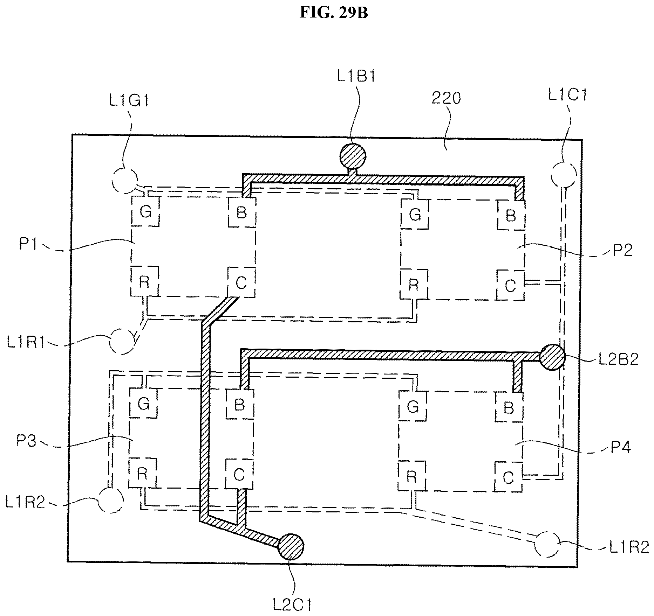

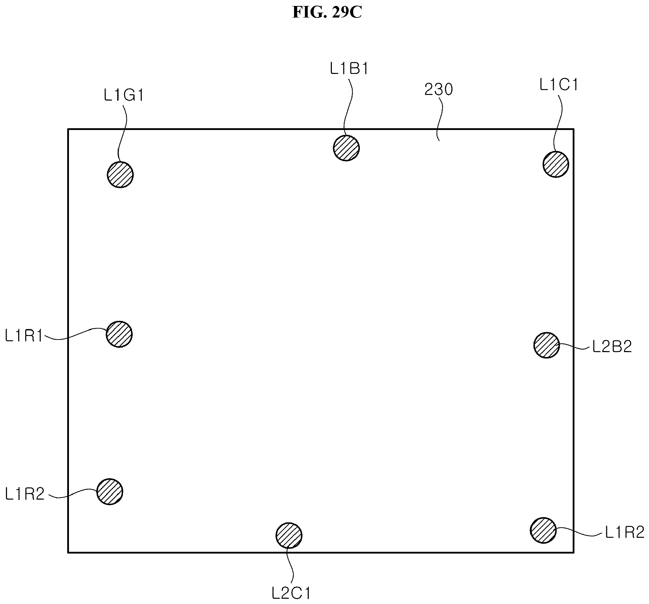

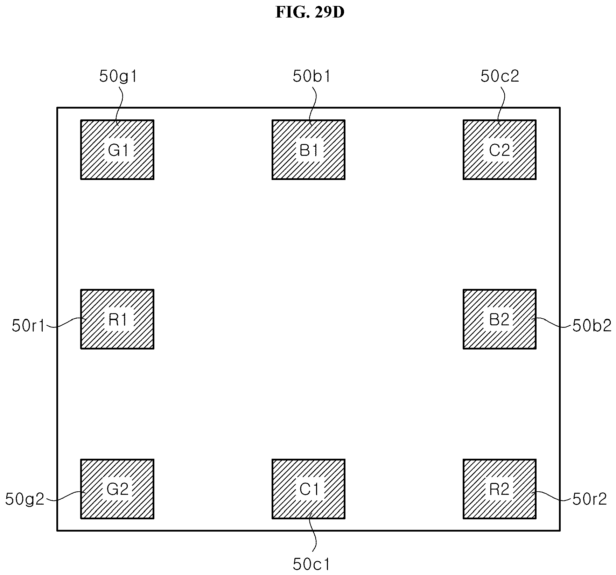

FIGS. 29A, 29B, 29C, and 29D are schematic plan views illustrating a method of forming a pad of a pixel device according to an exemplary embodiment. Herein, as an example, a method of forming the circuit of FIG. 6 will be described.

First, referring to FIG. 29A, pixels P1, P2, P3, and P4 may have four pixel pads R, G, B, and C, respectively. These pixel pads R, G, B, and C may be, for example, the first through fourth pads 20pd, 30pd, 40pd, and 50pd described with reference to FIGS. 12A, 12B, and 12C, or may be the bump pads 150 of FIG. 26. The pixel pads R, G, and B represent individual pixel pads electrically connected to the light emitting stacks, respectively, and the pixel pad C represents a common pixel pad commonly electrically connected to the light emitting stacks.

A first interconnection layer (e.g., L1 in FIG. 5 or FIG. 7) is formed on a planarization layer 60 or a lower insulation layer 140, and the first interconnection layer electrically connects same kind of pixel pads of adjacent pixels as shown in FIG. 29A. For example, the pixel pads R and G of a first pixel P1 may be respectively connected to the pixel pads R and G of a second pixel P2, and the pixel pads R and G of a third pixel P3 may be respectively connected to the pixel pads R and G of a fourth pixel P2. Meanwhile, the pixel pad C of the second pixel may be connected to the pixel pad C of the fourth pixel P4. Pads L1R1, L1G1, L1R2, L1G2, and L1C2 may be provided in the first interconnection layers connecting the pixel pads, respectively.

Referring to FIG. 29B, a first intermediate layer (120 in FIG. 5) covering the first interconnection layer is formed, and a second interconnection layer (e.g., L2 in FIG. 5 or FIG. 7) is formed on the first intermediate layer. The second interconnection layer may also electrically connect same kind of pixel pads of adj acent pixels. For example, the pixel pad B of the first pixel P1 may be connected to the pixel pad B of the second pixel P2, and the pixel pad B of the third pixel P3 may be connected to the pixel pad B of the fourth pixel P4. Also, the pixel pad C of the first pixel P1 may be connected to the pixel pad C of the third pixel P3. In addition, pads L2B1, L2B2, and L2C1 may be provided in the second interconnection layers connecting the pixel pads, respectively. As such, the same kind of pixel pads of adjacent pixels are electrically connected to one another by the first interconnection layer and the second interconnection layer.

Referring to FIG. 29C, a second intermediate layer (e.g., 130 in FIG. 5) may be formed on the second interconnection layer, the second intermediate layer 130 may be patterned to expose the pads L2B1, L2B2, and L2C1, and the first and second intermediate layers 120 and 130 may be patterned to expose the pads L1R1, L1G1, L1R2, L1G2, and L1C2.

Referring to FIG. 29D, pixel device pads 50r1, 50g1, 50b1, 50r2, 50g2, 50b2, 50c1, and 50c2 are formed on the pads, respectively. The pixel device pads 50r1, 50g1, 50b1, 50r2, 50g2, 50b2, 50c1, and 50c2 may be formed so as to have larger areas than those of the pixel pads 20pd, 30pd, 40pd, and 50pd.

In the illustrated exemplary embodiment, an example in which the first interconnection layer and the second interconnection layer connect adjacent pixel pads has been described, but the inventive concepts are not limited thereto. Adjacent pixel pads may be connected to one another in various ways using the first interconnection layer and the second interconnection layer. For example, the first interconnection layer may interconnect individual pixel pads R, B, and G of adjacent pixels P1, P2; P3, P4, and the second interconnection layer may interconnect the common pixel pads C of adjacent pixels P1, P3; P2, P4.

Although certain exemplary embodiments and implementations have been described herein, other embodiments and modifications will be apparent from this description. Accordingly, the inventive concepts are not limited to such embodiments, but rather to the broader scope of the appended claims and various obvious modifications and equivalent arrangements as would be apparent to a person of ordinary skill in the art.

## Claims

1. A pixel device, comprising:
a pixel;
a planarization layer covering side surfaces and an upper surface of the pixel; and
pixel device pads disposed on the planarization layer;
the pixel, comprising:
a first light emitting stack;
a second light emitting stack disposed under the first light emitting stack;
a third light emitting stack disposed under the second light emitting stack; and
pixel pads electrically connected to the first through third light emitting stacks; wherein:
the pixel device pads are electrically connected to the pixel pads through the planarization layer, and
at least a portion of each of the pixel device pads extends from an upper region of the pixel to an inner surface of the planarization layer formed between the planarization layer and the pixel.

2. The pixel device of claim 1, wherein:
the planarization layer has an opening exposing the pixel pads, and
the pixel device pads are electrically connected to the pixel pads through the opening.

3. The pixel device of claim 2, further comprising:
a protection layer covering the opening.

4. The pixel device of claim 3,
wherein the protection layer covers the pixel device pads, and has openings exposing the pixel device pads.

5. The pixel device of claim 1, further comprising:
a transparent substrate; and
an adhesive layer disposed between the transparent substrate and the pixel to attach the pixel to the transparent substrate.

6. The pixel device of claim 5, further comprising:
a light blocking layer disposed on the transparent substrate to define a light emitting region,
wherein the pixel is disposed on the light emitting region.

7. The pixel device of claim 1, comprising:
at least two pixels.

8. The pixel device of claim 7, further comprising:
at least one interconnection layer disposed on the planarization,
wherein the pixel device pads are electrically connected to the pixel pads through the interconnection layer.

9. The pixel device of claim 8, further comprising:
a first intermediate layer disposed on the planarization layer; and
a second intermediate layer disposed on the first intermediate layer, wherein:
the interconnection layer includes a first interconnection layer disposed between the planarization layer and the first intermediate layer, and a second interconnection layer disposed between the first intermediate layer and the second intermediate layer, and
the pixel device pad is disposed on the second intermediate layer and electrically connected to the pixel pads through the first and second interconnection layers.

10. The pixel device of claim 9, further comprising:
a lower insulation layer disposed between the planarization layer and the first interconnection layer.

11. The pixel device of claim 7, wherein:
the plurality of pixels is arranged in a matrix of n × m (n, m is a positive integer), and
the number of the pixel device pads is less than 4×n×m.

12. The pixel device of claim 11,
wherein the number of the pixel device pads is (3n+m) or more and 2×n×m or less.

13. The pixel device of claim 7,
wherein lower surfaces of the pixels are exposed to a bottom surface of the pixel device.

14. The pixel device of claim 1,
wherein a size of one side of the pixel device is 1.5 times or more of a size of one side of the pixel.

15. The pixel device of claim 2,
Wherein an inner surface of the planarization layer defining the opening includes an inclined surface, and the pixel device pad disposed on an upper surface of the planarization layer is connected to the pixel pad disposed on the inner surface of the planarization layer at a predetermined angle (θ).

16. The pixel device of claim 15, wherein the pixel device pad is formed along a side surface of the light emitting stack and the inner surface of the planarization layer to form a groove, and a bottom surface of the groove is formed toward a light emission direction.

17. The pixel device of claim 15, wherein a distance between the pixel device pads formed on the inner surface of the planarization layer increases as a distance from the light emitting stack increases.

18. A display apparatus, comprising:
a circuit board; and
a pixel device disposed on the circuit board,
the pixel device, comprising:
a pixel;
a planarization layer covering side surfaces and an upper surface of the pixel; and
pixel device pads disposed on the planarization layer;
the pixel, comprising:
a first light emitting stack;
a second light emitting stack disposed under the first light emitting stack;
a third light emitting stack disposed under the second light emitting stack; and
pixel pads electrically connected to the first through third light emitting stacks; wherein:
the pixel device pads are electrically connected to the pixel pads through the planarization layer,
at least a portion of each of the pixel device pads is disposed on the planarization layer outside of an upper region of the pixel, and
the pixel device pads are bonded to the circuit board.

19. The display apparatus of claim 18,
the pixel device, further comprising: at least one interconnection layer disposed on the planarization, wherein:
the pixel device includes a plurality of pixels,
the planarization layer covers side surfaces and upper surfaces of the plurality of pixels,
the pixel device pads are disposed over the interconnection layer, and
the pixel device pads are electrically connected to the pixel pads through the interconnection layer.

20. The display apparatus of claim 19,
the pixel device, further comprising:
a first intermediate layer disposed on the planarization layer; and
a second intermediate layer disposed on the first intermediate layer, wherein:
the interconnection layer includes a first interconnection layer disposed between the planarization layer and the first intermediate layer, and a second interconnection layer disposed between the first intermediate layer and the second intermediate layer, and
the pixel device pad is disposed on the second intermediate layer and electrically connected to the pixel pads through the first and second interconnection layers.
